# EUROPEAN PATENT APPLICATION

(11) **EP 1 418 160 A1**
(43) Date of publication of application: **12.05.2004**
(21) Application number: 02746121.9
(22) Date of filing: 19.07.2002
(51) Int. Cl.: C04B 37/00, H01L 21/68

(54) **CERAMIC CONNECTION BODY, METHOD OF CONNECTING THE CERAMIC BODIES, AND CERAMIC STRUCTURAL BODY**

(30) Priority: 19.07.2001 JP 2001220385
(71) Applicant: IBIDEN CO., LTD., Ogaki-shi Gifu-ken 503-0917 (JP)
(72) Inventor: ITO, Yasutaka, c/o IBIDEN CO., LTD., Ibigawa-cho, Ibi-gun, Gifu 501-0601 (JP); OZAKI, Jun, c/o IBIDEN CO., LTD., Ibigawa-cho, Ibi-gun, Gifu 501-0601 (JP)
(74) Representative: Grünecker, Kinkeldey, Stockmair & Schwanhäusser Anwaltssozietät
(86) International application number: PCT/JP2002/007362
(87) International publication number: WO 2003/008359

(57) **Abstract**

It is to provide a ceramic joint body and a ceramic structural body effectively used in semiconductor production and inspection devices including a hot plate or the like, and proposes a ceramic joint body by joining ceramic bodies to each other, in which coarse pores having an average diameter larger than an average particle size of ceramic particles constituting the ceramic body and a size of not more than 2000 µm are formed in a joining interface between the one ceramic body and the other ceramic body as well as a method of joining ceramics to each other.

## Description

### TECHNICAL FIELD

This invention relates to a ceramic joint body and a joining method and a ceramic structural body, and more particularly to a substrate used in a semiconductor producing and inspecting apparatus such as a temperature control element in an optical communication field, a hot plate (ceramic heater), an electrostatic chuck, a susceptor or the like, for example, a ceramic substrate provided in its interior with a conductor as well as a ceramic structural body formed by joining a ceramic cylindrical member to a bottom face of the substrate.

### BACKGROUND ART

In the semiconductor producing and inspecting apparatus including an etching device, a chemical vapor growing device and the like have hitherto been used a heater, an electrostatic chuck and the like using a metal substrate such as stainless steel, aluminum alloy or the like.

For instance, the heater of the metal substrate has the following problems. Since the substrate is made of the metal, the thickness of the substrate should be thickened to about 15 mm. Because, in case of the thin metal plate, warping, straining and the like are caused by thermal expansion resulted from the heating and hence a silicon wafer placed on the metal plate is broken or inclined. On the other hand, as the thickness of the substrate becomes thicker, the weight of the heater increases and the volume becomes bulk. Further, When the temperature of the face heating a material to be heated such as silicon wafer or the like (hereinafter referred to as a heating face) is controlled by changing a voltage or a current quantity applied to a resistor heating body, since the thickness of the heater of the metal substrate is thick, the temperature of the substrate is not rapidly followed to the change of the voltage or current quantity and there is a problem that the temperature control is difficult.

On the contrary, JP-A-4-324276 and the like propose that a non-oxide ceramic having a high thermal conductivity and a large strength, for example, a hot plate made of aluminum nitride or the like (ceramic heater) is used instead of the metal substrate. This hot plate is constructed by forming a resistor heating body and a through-hole of tungsten in the ceramic substrate and soldering a nickel-chromium wire there to as an external terminal.

In such a ceramic hot plate, since the ceramic substrate having a large mechanical strength at a high temperature is used, the thickness of the substrate can be thinned and a heat capacity can be made small, and hence there is an advantage that the temperature of the substrate can be rapidly followed to the change of the voltage or the current quantity.

In such a hot plate, as disclosed in JP-A-2000-114355, a cylindrical ceramic and a disc-shaped ceramic are joined through a heat resistant adhesive, a ceramic joint layer or the like, or joined by applying a solution containing a joining assistant to a joint face to take means for protecting a wiring such as an external terminal or the like from a reactive gas, a halogen gas or the like used in the semiconductor production step. Moreover, there is a method as described in Japanese Patent No. 2783980 as the ceramic joining method.

However, when the ceramic cylinder and the disc-shaped ceramic plate are joined through a heat resistant adhesive, a ceramic joint layer or the like and the resulting joint body is applied to a hot plate, since the corrosion resistance is insufficient, as it is exposed to a reactive gas, a halogen gas or the like for a long time, the joined portion is corroded and can not be used, and also the ceramic particles are dropped off and adhered to the silicon wafer to cause the occurrence of particles. Furthermore, when the disc-shaped ceramic is broken by the thermal shock, there is caused a problem that cracking grows into the ceramic cylinder to corrode the wiring and the device portion connected to the wiring.

It is, therefore, an object of the invention to provide a ceramic joint body and a ceramic structural body effective for use in a semiconductor producing and inspecting apparatus such as a temperature control element in an optical communication field, a hot plate or the like.

It is another object of the invention to provide a ceramic joint body and a ceramic structural body preventing that even if it id exposed to a corrosive gas for a long period in the production and inspection of the semiconductor, the joining portion between the ceramics is corroded to generate particles.

It is the other object of the invention to provide a ceramic joint body and a ceramic structural body capable of preventing the progressing of crack in one of the ceramics due to thermal shock to crack of the other ceramic to be joined.

It is a further object of the invention to provide a method capable of joining the ceramic joint bodies to each other for achieving the above objects.

### DISCLOSURE OF THE INVENTION

The inventors have made various studies for solving the aforementioned problems of the conventional techniques and found that these problems can be solved when coarse pores are positively introduced to render the joining interface between the ceramics into porous structure different from the dense structure (Patent No. 2783980), i.e. the corrosion of the joining interface through the reactive gas can be effectively prevented and the progress of the crack produced in one of the ceramic bodies through thermal shock to the other ceramic body joined thereto can be effectively prevented. Further, it has been found that such a joining structure can be applied to various ceramic goods in addition to the semiconductor producing and inspecting apparatus, and as a result the invention has been accomplished.

According to the invention, it has been further found that the effect capable of stopping the temperature drop of one of the ceramic bodies at minimum is developed by controlling the heat transfer from one of the ceramic bodies to the other ceramic body.

That is, a first aspect of the invention proposes a ceramic joint body formed by joining ceramic bodies to each other, characterized in that pores are formed in a joining interface between one of the ceramic bodies and the other ceramic body.

Concretely, the invention is preferable to be a form that in the ceramic joint body formed by joining one ceramic body to the other ceramic body, a joining assistant layer is arranged in a joining interface between the one ceramic body and the other ceramic body and pores are formed in the joining assistant layer, or a form that in the ceramic joint body formed by joining one ceramic body to the other ceramic body, at least a part of ceramic particles constituting the each ceramic body and existing in a joining interface is constituted by grown particles penetrated into these ceramic bodies across the joining interface and pores are formed in the joining interface.

Moreover, in the invention, it is desirable that the pores are flat in its sectional shape. Also, it is preferable that the pore is a coarse pore having a size of not more than 2000 µm.

A second aspect of the invention proposes a ceramic joint body formed by joining ceramic bodies, characterized in that coarse pores having an average diameter larger than 1/2 of an average particle size of ceramic particle constituting the ceramic body and a size of not more than 2000 µm are formed in a joining interface between the one ceramic body and the other ceramic body.

Concretely, this invention is preferable to take a form that in the ceramic joint body formed by joining the one ceramic body to the other ceramic body, a joining assistant layer is arranged in the joining interface between these ceramic bodies and coarse pores having an average diameter larger than 1/2 of the average particle size of the ceramic particle constituting the ceramic body and a size of not more than 2000 µm are formed in the joining assistant layer, or
a form that in the ceramic joint body formed by joining one ceramic body to the other ceramic body, at least a part of the ceramic particles constituting each ceramic body and existing in the joining interface is constructed with grown particles penetrated into each of the ceramic bodies across the joining interface and coarse pores having an average diameter larger than 1/2 of the average particle size of the ceramic particle constituting the ceramic body and a size of not more than 2000 µm are formed in the joining interface.

A third aspect of the invention proposes a ceramic joint body formed by joining ceramic bodies to each other, characterized in that coarse pores having an average diameter larger than an average particle size of a ceramic particle constituting the ceramic body and a size of not more than 2000 µm are formed in a joining interface between the one ceramic body and the other ceramic body.

Concretely, this invention is preferable to take a form that in the ceramic joint body formed by joining the one ceramic body to the other ceramic body, a joining assistant layer is arranged in the joining interface between these ceramic bodies and coarse pores having an average diameter larger than the average particle size of the ceramic particle constituting the ceramic body and a size of not more than 2000 µm are formed in the joining assistant layer, or
a form that in the ceramic joint body formed by joining one ceramic body to the other ceramic body, at least a part of the ceramic particles constituting each ceramic body and existing in the joining interface is constructed with grown particles penetrated into each of the ceramic substrates and ceramic bodies across the joining interface and coarse pores having an average diameter larger than the average particle size of the ceramic particle constituting the ceramic body and a size of not more than 2000 µm are formed in the joining interface.

Moreover, in the invention, it is preferable that the coarse pores formed in the joining interface are gas-enclosed pores formed among the surface of the one ceramic body, the surface of the other ceramic body and grown ceramic particles produced by the grain growth irrespectively of opened pores or closed pores in the ceramic body. In order to produce such coarse pores in the joining interface, it is preferable to render the surface roughness of each joining face of each ceramic body into Rmax = not less than 0.1 µm by JIS B0601. And also, the invention is preferable to be a structural body used by applying to a temperature control element, a semiconductor producing and inspecting apparatus in an optical communication field, particularly a hot plate (ceramic heater), an electrostatic chuck, a susceptor or the like and used by incorporating into a plasma CVD, a sputtering device or the like.

A fourth aspect of the invention proposes a ceramic structural body formed by joining a ceramic substrate provided in its inside with a conductor to a ceramic body, characterized in that pores are formed in a joining interface between the ceramic substrate and the ceramic body.

Concretely, this invention is preferable to take a form that in the ceramic structural body formed by joining the ceramic substrate provided in its inside with the conductor to the ceramic body, a joining assistant layer is arranged in the joining interface between the ceramic substrate and the ceramic body and pores are formed in the joining assistant layer, or
a form that in the ceramic structural body formed by joining the ceramic substrate provided in its inside with the conductor to the ceramic body, at least a part of the ceramic particles constituting the ceramic substrate and the ceramic body is constructed with grown particles penetrated into the ceramic substrate and the ceramic body on the other side across the joining interface and pores are formed in the joining interface.

Moreover, in the invention, the pores are desired to be flat in the sectional shape. Also, the pores are preferable to be coarse pores having a size of not more than 2000 µm.

A fifth aspect of the invention proposes a ceramic structural body formed by joining a ceramic substrate provided in its inside with a conductor to a ceramic body, characterized in that coarse pores having an average diameter larger than 1/2 of an average particle size of ceramic particles constituting the ceramic body and a size of not more than 2000 µm are formed in a joining interface between the ceramic substrate and the ceramic body.

Concretely, this invention is preferable to take a form that in the ceramic structural body formed by joining the ceramic substrate provided in its inside with the conductor to the ceramic body, a joining assistant layer is arranged in the joining interface between the ceramic substrate and the ceramic body and coarse pores having an average diameter larger than 1/2 of the average particle size of the ceramic particles constituting the ceramic body and a size of not more than 2000 µm are formed in the joining assistant layer, or
a form that in the ceramic structural body formed by joining the ceramic substrate provided in its inside with the conductor to the ceramic body, at least a part of the ceramic particles constituting the ceramic substrate and the ceramic body is constructed with grown particles mutually penetrated into the ceramic substrate and the ceramic body on the other side across the joining interface and coarse pores having an average diameter larger than 1/2 of the average particle size of the ceramic particles constituting the ceramic body and a size of not more than 2000 µm are formed in the joining interface.

A sixth aspect of the invention proposes a ceramic structural body formed by joining a ceramic substrate provided in its inside with a conductor to a ceramic body, characterized in that coarse pores having an average diameter larger than an average particle size of ceramic particles constituting the ceramic body and a size of not more than 2000 µm are formed in a joining interface between the ceramic substrate and the ceramic body.

Concretely, this invention is preferable to take a form that in the ceramic structural body formed by joining the ceramic substrate provided in its inside with the conductor to the ceramic body, a joining assistant layer is arranged in the joining interface between the ceramic substrate and the ceramic body and coarse pores having an average diameter larger than the average particle size of the ceramic particles constituting the ceramic body and a size of not more than 2000 µm are formed in the joining assistant layer, or
a form that in the ceramic structural body formed by joining the ceramic substrate provided in its inside with the conductor to the ceramic body, at least a part of the ceramic particles constituting the ceramic substrate and the ceramic body is constructed with grown particles mutually penetrated into the ceramic substrate and the ceramic body on the other side across the joining interface and coarse pores having an average diameter larger than the average particle size of the ceramic particles constituting the ceramic body and a size of not more than 2000 µm are formed in the joining interface.

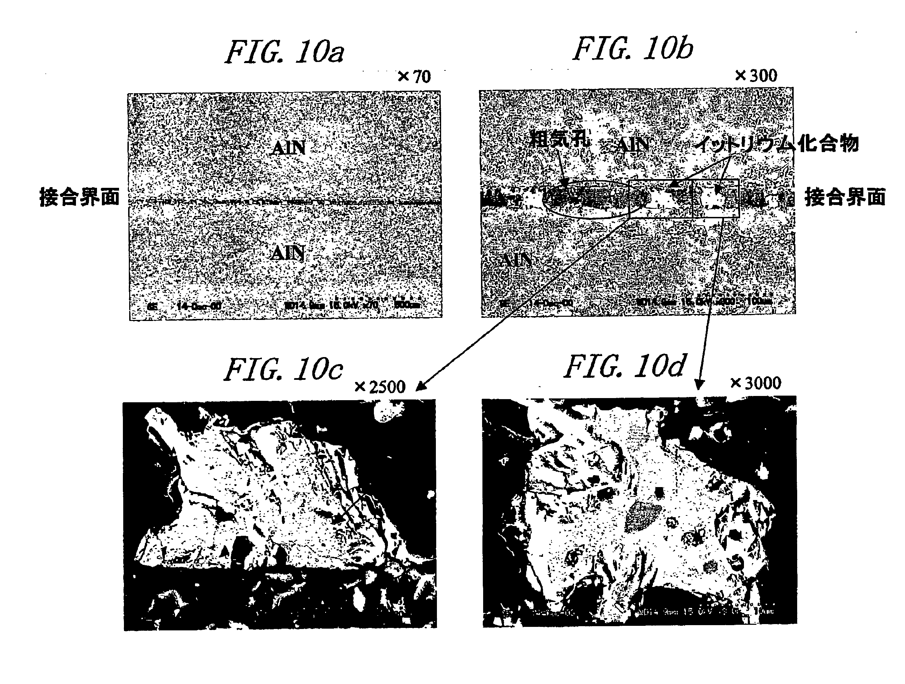

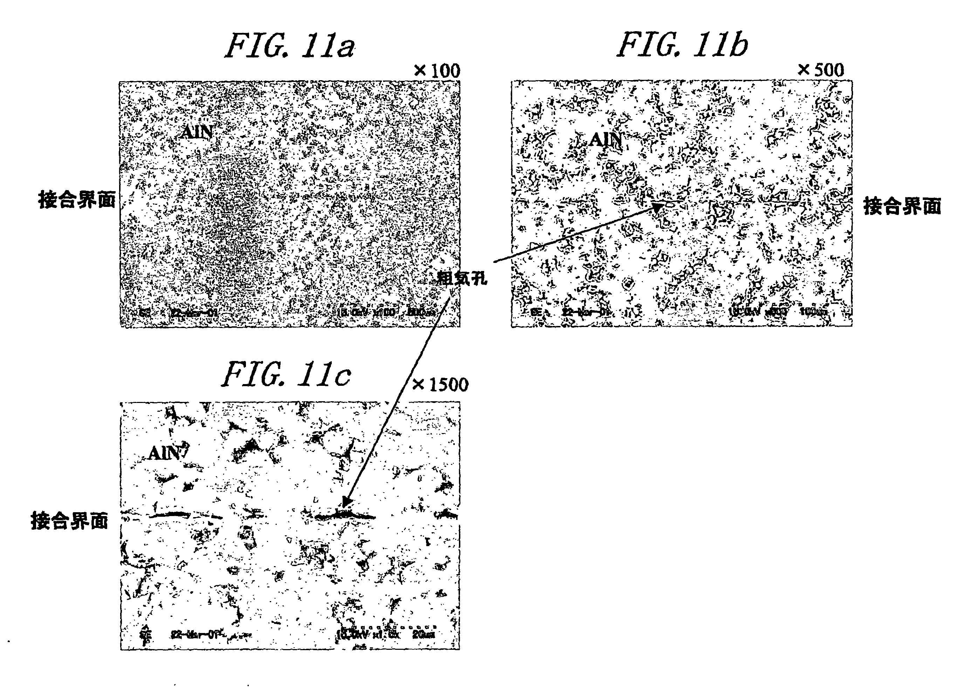

In each aspect of the invention, the coarse pores formed in the joining interface are existent in the joining assistant layer, which are different from opened pores or closed pores usually produced in the ceramic substrate and the ceramic body. It is preferable that the joining assistant layer is constructed by the surface of the ceramic substrate and the surface of the ceramic body, or is formed between the surface of the ceramic substrate and the surface of the ceramic body and ceramic grown particles produced by grain growth and a sectional shape thereof is flat (see FIGS. 10, 11).

Also, it is preferable that the coarse pores are gas filled gaps, and a conductor body electrically connected to a conductor body inside the ceramic substrate is embedded in the interior of the ceramic body or received in a cylindrical inside of a cylindrical ceramic body, and the ceramic particles are made of aluminum nitride or silicon nitride, and the joining assistant is one or more selected from yttrium compounds and ytterbium compounds.

In the above ceramic joint body according to the invention, when one ceramic body is joined to the other ceramic body, a surface of at least one of these ceramic bodies to be joined is first mirror-polished to less than 0.1 µm of Rmax and then the mirrored surface is subjected to a blast treatment so as to be a roughness having Rmax of not less than 0.1 µm and Ra of more than 0.1 µm, and a joining assistant using a yttrium compound and/or ytterbium compound is directly applied to the joining surface and fired at a temperature of not higher than 1800°C, whereby the joining can be conducted.

As seen from the above, the invention lies in that the surface roughness (Rmax) of the joining interface between the ceramic bodies is made large to facilitate the formation of pores filled with a gas such as air or the like in the joining interface, and even if corrosive plasma gas such as halogen, CF₄ or the like is penetrated in the presence of these pores, the penetrated gas is deactivated by the collision with oxygen, nitrogen and argon in the pores and hence the progress of the corrosion can be prevented. Further, according to the invention, even if crack is caused in one of the ceramic bodies or the like through thermal shock, the progress of the crack stops at the pore portion in the joining interface, so that the pores develop the action of hardly transferring to the other ceramic body or the like.

According to the invention, gaps having a flat shape at section are arranged along the interface between the ceramic bodies (ceramic substrate and ceramic body), which render into heat resistance for preventing thermal conduction from the one ceramic body (ceramic substrate) to the other ceramic body. For this end, there is an advantage that the temperature uniformity of the ceramic body (ceramic substrate) does not lower. In this point, if the shape of the pore is not flat, the function of heat resistance lowers and hence the temperature of the ceramic body (ceramic substrate) lowers at the back face of the joined portion.

An aspect ratio of the pore of a flat shape at section formed along the joining interface (length L of the pore in the interface direction to thickness 1 in a direction perpendicular to the interface) is L/l > 1.

Moreover, as the surface roughness is made large, the joining interface area becomes large, which means that the lowering of the joining strength can be controlled to a certain extent and has an advantage that even if the pores are positively formed, the joining strength is not immediately lowered.

In addition, it is desirable in the invention that when the joining assistant layer is formed at the joining interface, the pores are formed in the joining assistant layer. Such a joining assistant layer means a layer-like region having a relatively large concentration of the joining assistant in addition to a layer consisting essentially of the joining assistant. For instance, in an electron microphotograph of a joining interface of AlN shown in FIG. 10, a black portion at the central joining interface shows the pores and a white discontinuous portion shows the joining assistant layer of yttrium compound.

These pores are preferable to be coarse pores having a size larger than an average diameter of each ceramic powder constituting the ceramic structure and being not more than 2000 µm. Also, the thickness of the joining assistant layer is preferable to be about 0.1-100 µm. Since the ceramic bodies are adhered to each other through the presence of the joining assistant, the thickness is desirable to be the above range. Preferably, the thickness is about 1-50 µm. Moreover, the average diameter of the pore is an average of measured values when the section of the joining interface are pictured at 10 places by means of an electron microscope to measure sectional diameter of the pore in each pictured image.

FIG. 11 is an electron microphotograph of a joining interface having a structure that ceramic particles in the one ceramic body having a surface roughness Rmax of not less than 0.1 µm are penetrated into the other ceramic body over the joining interface by grain growth. Even in this case, the coarse pores are formed in the joining interface. That is, ceramic particles of the ceramic body (AlN) are penetrated into the other ceramic body over the joining interface by the grain growth. In this embodiment, the joining assistant layer is not existent in the joining interface between the one ceramic body and the other ceramic body, and the grain-grown ceramic particles largely grow and penetrate into both the ceramic bodies and are integrated to each other to render the boundary into a disappeared state, whereby both the bodies are strongly joined. Further, the coarse pores formed in such a joining stage are produced over each boundary portion between the surface of the ceramic body and the grown particles.

The coarse pores formed in the joining interface are not open pores or closed pores formed on the surface of the ceramic body and are clearly distinguished therefrom and are newly produced and formed among the surface of the one ceramic body, the surface of the other ceramic body and the grain grown ceramic particles during the heat treatment.

As the ceramic is preferably used aluminum nitride or silicon nitride. As the joining assistant are desirably used yttrium compounds and ytterbium compounds. The yttrium compound and ytterbium compound are sintering aid for aluminum nitride or silicon nitride and have an advantage that the grain growth is easily caused.

The coarse pores are not more than 2000 µm as an upper limit of the average diameter. If pores having an average diameter of more than 2000 µm are existent, the joining strength lowers and crack proceeds. Moreover, the diameter is a diameter viewing at section, and is determined by shooting the section of the joining interface with an electron microscope and measuring a length of the pore. Such a shooting is carried out at arbitrary 10 places, and the obtained diameters viewing at section are averaged.

On the other hand, when the average diameter of the coarse pore is not more than an average diameter of each ceramic particle, the coarse pores can not obstruct the progress of the corrosion and do not stop the growing of the crack. Since the crack grows along the particle boundary, when the average pore size of the coarse pore is smaller than the particle size, the growing of the crack is not stopped.

Moreover, the measurement of the average diameter of the ceramic particle is carried out by shooting a cut face or a polished face with the electron microscope 10 times. Since the ceramic particles are not necessarily spheres, maximum diameter and minimum diameter are measured and the values are averaged. The average diameter of the ceramic particle is obtained by averaging particle sizes of the shot images. In general, it is common that the diameter of the ceramic particle is larger than the diameter of the starting powder. Because the particles are grown by sintering. The average diameter of the ceramic particle is desirably 0.5-50 µm, and particularly is optimum to be 1-20 µm. When it is less than 0.5 µm, the thermal conductivity and strength lower in the presence of grain boundary, while when it exceeds 50 µm, lattice defect is caused in the grain growth and the thermal conductivity and strength lower.

Also, the coarse pores having a size that the average diameter exceeds 1/2 of the average diameter of each ceramic particle and is not more than 2000 µm are optimum in view of preventing thermal conduction between the ceramic bodies. When the average diameter of the pore is less than 1/2 of the average diameter of the ceramic particle, the thermal conduction is caused by ceramic crystal lattice, while when it exceeds 2000 µm, heat is conducted by radiation instead of the conduction and finally the thermal conduction can not be prevented. The above range is optimum from a viewpoint of the thermal conduction.

In the invention, the following joining method is advantageously adaptable in the production of the above ceramic joint body.

Method 1: At first, the surface of the ceramic body is mirror-polished to a mirror surface of JIS R0601 Rmax = less than 0.1 µm and thereafter subjected to a sand blast treatment to a coarse surface of JIS R0601 Rmax = not less than 0.1 µm. In this case, it is desirable to exceed Rmax over 0.1 µm. Then, a solution of at least one joining assistant selected from yttrium compounds and ytterbium compounds is applied in a concentration of not less than 0.30 mol/l to a portion corresponding to a joining interface to the one ceramic body and/or the other ceramic body and fired below 1800°C. Moreover, when the concentration of the joining assistant is higher than the above numerical value or when the firing temperature is lowered, the diffusion of the joining assistant hardly proceeds and the aggregation of the particles occurs.

That is, according to the invention, the coarse pores can be generated and introduced in the joining assistant layer by adopting the above joining method. On the other hand, the particles in the ceramic body grow and penetrate into the joining assistant layer, so that the ceramic bodies are more strongly bonded to each other through the joining assistant layer.

Method 2: At first, the surface of the ceramic body is mirror-polished to a mirror surface of JIS R0601 Rmax = less than 0.1 µm and thereafter subjected to a sand blast treatment to a coarse surface of JIS R0601 Rmax = not less than 0.1 µm. Then, a solution of a joining assistant such as yttrium compounds and ytterbium compounds is applied in a concentration of not more than 0.20 mol/l to a portion corresponding to a joining interface to the one ceramic body and/or the other ceramic body and fired below 1800°C. When the concentration of the joining assistant is lowered and the firing temperature is lowered, the growth of the ceramic particles is partial and the pores generate. However, the grain growth itself proceeds and penetrates into each other over the joining interface and integrally bonded so as to erase the boundary.

As to the surface roughness, Japanese Patent 2783980 aims at the average roughness Ra and renders it into not more than 0.1 µm, while the invention aims at the maximum roughness Rmax. Ra is an average surface roughness, and Rmax is a height difference between maximum mountain and maximum valley, so that both are different. In the invention, the indication Rmax is adopted for easily introducing the above coarse pores, and Rmax is adjusted to more than 0.1 µm. When the surface roughness is Ra: about 0.1 µm, the surface of the ceramic body is substantially a complete mirror surface, which can not form pores required in the invention.

Further, Japanese Patent 2783980 discloses that the concentration of the joining assistant is 0.26 mol/l and the firing temperature is not lower than 1850°C. In the invention, the firing temperature is not higher than 1800°C, preferably not higher than 1750°C, and the concentration of the joining assistant is not less than 0.30 mol/l or not more than 0.20 mol/l, whereby desired large pores are generated in the joining interface to attain the corrosion resistance and the prevention of crack growth.

Moreover, when the concentration of the joining assistant is within a range of 0.20-0.30 mol/l, the joining assistant rapidly diffuses and the particles constituting the ceramic sufficiently grow, so that the joining can be conducted without generating the pores in the joining interface. In this meaning, the invention is entirely different from the technique of the above patent.

In the joining, the ceramic bodies may be sintered only by their own weight, but the joining may be conducted by pressing under about 5-100 g/cm² (0.49-9.8 kPa/cm²).

### BRIEF DESCRIPTION OF THE DRAWINGS

FIGS. 1a to 1d are section views schematically illustrating an embodiment of the production method of a hot plate as an example of the ceramic composite body according to the invention.
FIG. 2 is a schematically bottom view of the hot plate as an example of the ceramic composite body according to the invention.
FIG. 3 is a section view of the hot plate shown in FIG. 2.
FIG. 4 is a partially enlarged section view schematically illustrating a ceramic substrate constituting the hot plate shown in FIG. 2.
FIG. 5 is a schematically longitudinal section view of a ceramic substrate constituting an antistatic chuck as an example of the ceramic composite body according to the invention.
FIG. 6 is a partially enlarged section view schematically illustrating the ceramic substrate constituting the antistatic chuck shown in FUG. 5.
FIG. 7 is a schematically horizontal section view of an example of the antistatic electrode embedded in the ceramic substrate.
FIG. 8 is a schematically horizontal section view of another example of the antistatic electrode embedded in the ceramic substrate.
FIG. 9 is a schematically horizontal section view of the other example of the antistatic electrode embedded in the ceramic substrate.
FIGS. 10a to 10d are electron microphotographs of a joining interface when pores are introduced into a joining agent layer.
FIGS. 11a to 11c are electron microphotographs of a joining interface when pores are introduced into the joining interface.
FIG. 12 is an electron microphotograph of a joining interface in case of not introducing pores.
FIG. 13 is a graph showing a relation between an aspect ratio of a pore and a temperature difference between maximum temperature and minimum temperature of a ceramic substrate.
FIG. 14 is a graph showing a relation between an average diameter of a coarse pore and a temperature difference between maximum temperature and minimum temperature of a ceramic substrate.
FIGS. 15a and 15b are a thermograph of a heating surface of a ceramic substrate in case of the presence or the absence of pores.

### BEST MODE FOR CARRYING OUT THE INVENTION

The invention will be described with reference to the following embodiment but is not limited to this embodiment.

At first, the ceramic composite body is described with respect to an example of joining a ceramic cylindrical body (referred to an example of "terminal protection cylinder") to a bottom surface of a ceramic substrate provided in its interior with an electric conductor.

At least one surface of the ceramic substrate and the terminal protection cylinder is first mirror-polished to JIS B0601 Rmax of less than 0.1 µm and thereafter subjected to a sand blast treatment to obtain a rough surface having a JIS B0601 Rmax of not less than 0.1 µm. Also, Ra is over 0.1 µm. The above polishing is carried out by using a diamond grinding stone or a diamond paste to form a mirror surface. On the other hand, the sand blast is carried out by blowing SiC, zirconia, alumina or the like.

In the invention, the reason why the mirror surface is formed before the formation of the rough surface is due to the fact that when the roughening treatment is conducted without the mirror polishing, unevenness is further formed on the original rough surface and it is difficult to control the roughened surface to the desired Rmax value in a higher reproducibility. That is, roughening treatment after mirror polishing leads to accurate control of Rmax in a higher reproducibility.

Then, a solution of a joining assistant (concentration: not less than 0.3 mol/l or not more than 0.2 mol/l) is applied to the joining interface of the ceramic substrate and/or the terminal protection cylinder, and the terminal protection cylinder is placed on the ceramic substrate after the above application step, and then the ceramic substrate and the terminal protection cylinder are heated below 1800°C to join both.

FIGS. 1a to 1d explain the embodiment of the invention and are section views schematically illustrating a part of the production method of the hot plate wherein a resistor heating body is embedded in the ceramic substrate.

### (1) Step of preparing green sheet

At first, ceramic powder such as aluminum nitride or the like is mixed with a binder, a solvent and the like to prepare a paste, and a green sheet 50 is prepared by a doctor blade method of the paste.

As the binder, it is desirable to select at least one from acrylic binder, ethyl cellulose, butyl cellosolve and polyvinyl alcohol. As the solvent is preferably used α-terpineol, glycol or the like. Moreover, a sintering aid such as yttria or the like may be added, if necessary.

The green sheet 50 is preferable to have a thickness of about 0.1-5 mm. In the preparation of the green sheet 50, there are prepared a green sheet 50 formed with a portion 630 corresponding to a viahole for connecting a terminal of the resistor heating body to a conductor circuit, and a green sheet 50 formed with portions 63, 63' corresponding to through-holes for connecting the conductor circuit to external terminals.

In the green sheet are also formed a portion corresponding to a through-hole inserting a lifter pin for transferring a silicon wafer, a portion corresponding to a recess attaching a support pin for supporting the silicon wafer, a portion corresponding to a bottomed hole for embedding a temperature measuring element such as a thermocouple and the like, if necessary. Moreover, the through-hole, recess and the bottomed hole may be formed after the formation of green sheet laminate as mentioned below, or after the firing the formed laminate.

In addition, carbon added to the paste may be filled in the portion 630 corresponding to the viahole and the portions 63, 63' corresponding to the through-holes. Because, carbon in the green sheet reacts with tungsten or molybdenum filled in the through-holes to form a carbide.

### (2) Step of printing conductor paste on green sheet

On the green sheet 50 formed with the portion 630 corresponding to the viahole is printed a metal paste or a conductor paste containing an electrically conductive ceramic (including metal particles or electrically conductive ceramic particles) to form a conductor paste layer 62.

The metal particles such as tungsten particles, molybdenum particles are preferable to have an average particle size of about 0.5 -5 µm. When the average particle size is less than 0.1 µm or exceeds 5 µm, the printing of the conductor paste is difficult.

As such a conductor paste is mentioned a composition (paste) comprising, for example, metal particles or electrically conductive particles: 85-87 parts by weight, at least one binder selected from acrylic, ethyl cellulose, butyl cellosolve and polyvinyl alcohol: 1.5-10 parts by weight, and at least one solvent selected from α-terpineol and glycol: 1.5-10 parts by weight.

Onto the green sheet 50 formed with the portions 63, 63' corresponding to the through-holes is printed a conductor paste usually used in the formation of electrostatic electrode or the like to form a conductor paste layer 68.

Moreover, a wire, foil or the like of a metal or an electrically conductive ceramic may be adhered to the green sheet 50 instead of the conductor paste.

### (3) Step of laminating green sheets

On the green sheet 50 printed with the conductor paste 62 are laminated a plurality of green sheets 50 not printed with the conductor paste and then a green sheet formed with the conductor paste 68 is laminated therebelow. Further, a plurality of unprinted green sheets 50 are laminated below the green sheet (FIG. 1a).

In this case, the position of forming the resistor heating body to be manufactured is deflected in a direction of bottom side by making the number of the green sheets laminated on the green sheet printed with the conductor paste layer 62 larger than the number of the green sheets 50 laminated therebelow. Concretely, it is preferable that the laminating number of upper side green sheets 50 is 20-50 and the laminating number of the lower side green sheets 50 is 5-20.

### (4) Step of firing green sheet laminate

The heating and pressing of the green sheet laminate are carried out to sinter the green sheets 50 and the conductor paste layers 62, 68 and the like inside thereof, whereby there are produced a ceramic substrate 11, resistor heating body 12 , conductor circuit 18 and the like. The heating temperature is preferable to 1000-2000°C, and the pressure of the pressing is preferable to about 10-20 MPa. The heating can be carried out in an inert gas atmosphere such as argon, nitrogen or the like.

Then, a bottomed hole for inserting a temperature measuring element is pierced in a bottom face 11b of the ceramic substrate 11 (not shown). The bottomed hole can be formed by drill work or a blast treatment such as sand blast or the like after the surface polishing. Moreover, the bottomed hole or the recess may be formed after the joining of the ceramic substrate 11 to the terminal protection cylinder 17 as mentioned below, or may be formed by laminating and firing the green sheets 50 after a portion corresponding to the bottomed hole is previously formed in the green sheet 50.

Also, blind holes 19 are formed for exposing through-holes 13, 13' for connecting to the interior resistor heating body 12. The blind holes 19 may be formed after the joining of the ceramic substrate 11 to the terminal protection cylinder 17.

### (5) Production of terminal protection cylinder

A ceramic powder such as aluminum nitride or the like is shaped in a cylindrical shaping mold and subjected to a cutting work, if necessary. Then, it is sintered at a heating temperature of 1000-2000°C under atmospheric pressure to produce a ceramic terminal protection cylinder 17. The sintering is conducted in an inert gas atmosphere. As the inert gas may be used, for example, argon, nitrogen or the like. In this case, it is desirable to include yttria or the like as a sintering aid in the ceramic powder Also, the terminal protection cylinder 17 has such a size of receiving in its interior through-holes 13, 13' formed in the inside of the ceramic substrate 11.

Then, an end face of the terminal protection cylinder 17 to be joined is flatened by polishing. For example, the surface of the ceramic body is mirror-polished to JIS B0601 Rmax of less than 0.1 µm and thereafter subjected to a sand blast treatment to JIS B0601 Rmax of not less than 0.1 µm. The polishing is conducted by using a diamond grinding stone or a diamond paste to render the surface into a mirror surface. The sand blast is conducted by SiC, zirconia, alumina or the like. A maximum surface roughness (JIS-B0601 Rmax) of a joining face between the ceramic substrate 11 and the cylindrical body 17 is not less than 0.1 µm. Because pores are easily produced in the joining face at more than 0.1 µm.

### (6) Step of applying joining assistant

As a joining assistant can be used a water-soluble yttrium chloride, yttrium sulfate, yttrium acetate and yttrium nitrate. The concentration in the solution is preferable to be not less than 0.3 mol/l or not more than 0.2 mol/l. As previously mentioned, the coarse pores are easily generated.

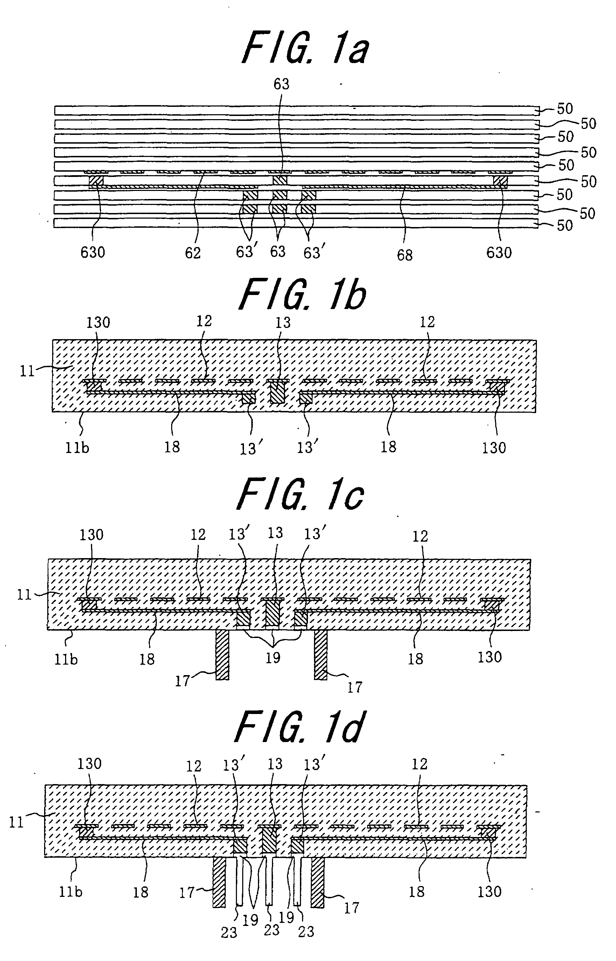

Then, a liquid body 210 is applied to the joining face of the ceramic substrate 11 and/or terminal protection cylinder 17 produced in the above step (5) (FIG. 1b).

As a solvent for the liquid are desirable water, alcohol and the like. The yttrium chloride is dissolved in such a solvent.

### (7) Step of joining ceramic substrate and terminal protection cylinder

The terminal protection cylinder 17 is placed on the ceramic substrate 11 after the application step of the above step (6) and the ceramic substrate 11 and the terminal protection cylinder 17 are heated to render the liquid body into a ceramic joining layer 21, and the ceramic substrate 11 and the terminal protection cylinder 17 are joined through such a ceramic joining layer 21. In this case, the terminal protection cylinder 17 is joined to the bottom face 11b of the ceramic substrate 11 so as to receive the through-holes 13, 13' in the ceramic substrate 11 inside an inner diameter of the terminal protection cylinder 17 (FIG. 1c).

Also, it is desirable that the ceramic substrate 11 and the terminal protection cylinder 17 are joined by pushing the terminal protection cylinder 17 onto the ceramic substrate 11 under a pressure of 0.49-9.8 kPa/cm² and heating them at such a state. Because both can be strongly joined by joining at such a pressurized state.

In the joining of the ceramic substrate 11 and the terminal protection cylinder 17, it is desirable to heat at a relatively low temperature of not higher than 1800°C. The concentration of the joining assistant is made not less than 0.3 mol/l or not more than 0.2 mol/l. Because, in the range of 0.2-0.3 mol/l, the joining assistant rapidly diffuses and the particles constituting the ceramic sufficiently grow and hence the joining can be conducted without generating pores in the joining interface.

In the invention, the diameter and shape of the pore are adjusted by particularly controlling Rmax and adjusting the Rmax to more than 0.1 µm and further adjusting the heating temperature in the joining to not higher than 1800°C.

### (8) Attachment of terminals and the like

External terminals 23 are filled in the blind holes 19 formed inside the terminal protection cylinder 17 together with a solder or soldering material and reflowed by heating to connect the external terminals 23 to the through-holes 13, 13' (FIG. 1d). The heating temperature is preferable to be 90-450°C in case of the solder and 900-1100°C in case of the soldering material.

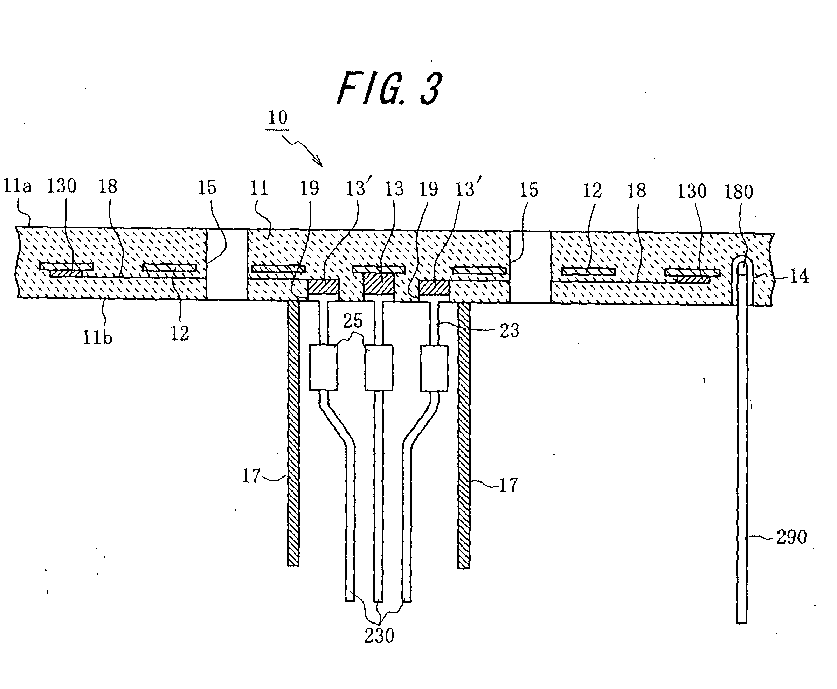

Then, the external terminals 23 are connected through sockets 25 to lead wires 230 being connected to a power source (see FIG. 3). Further, a thermocouple 180 or the like as a temperature measuring element is inserted into the bottomed hole 14 and sealed with a heat resistant resin or the like. Thus, there is produced a hot plate provided on its bottom face with the terminal protection cylinder of aluminum nitride.

The hot plate can be used for conducting operation of cleaning or the like while conducting the heating or cooling of a silicon wafer or the like after a semiconductor wafer such as silicon wafer or the like is placed on the upper surface of the hot plate or the silicon wafer or the like is held on the upper surface with a lifter pin, support pin or the like.

In the production of the hot plate, when the electrostatic electrode is arranged inside the ceramic substrate, the electrostatic chuck can be provided. In this case, however, it is required to form a through-hole for connecting the electrostatic electrode to the external terminal, but it is not required to form a through-hole for inserting the support pin.

When electrodes are arranged in the interior of the ceramic substrate, a conductor paste layer being an electrostatic electrode may be formed on the surface of the green sheet likewise the case of forming the resistor heating body.

When the joint body is used in an apparatus for the production and inspection of semiconductors, it is desirable that the ceramic substrate embedding an electric conductor in its interior is fixed to an upper part of a support vessel provided with a bottom plate and further a wiring from the conductor is housed in the terminal protection cylinder joined to the bottom surface of the ceramic substrate. Thus, the corrosion of the wiring cause by being exposed to a corrosive gas is prevented.

When the electric conductor formed in the interior of the ceramic substrate constituting the joint body according to the invention is resistor heating body and conductor circuit, the above joint body functions as a hot plate.

Then, the structure of the ceramic joint body according to the invention produced by the above method is described.

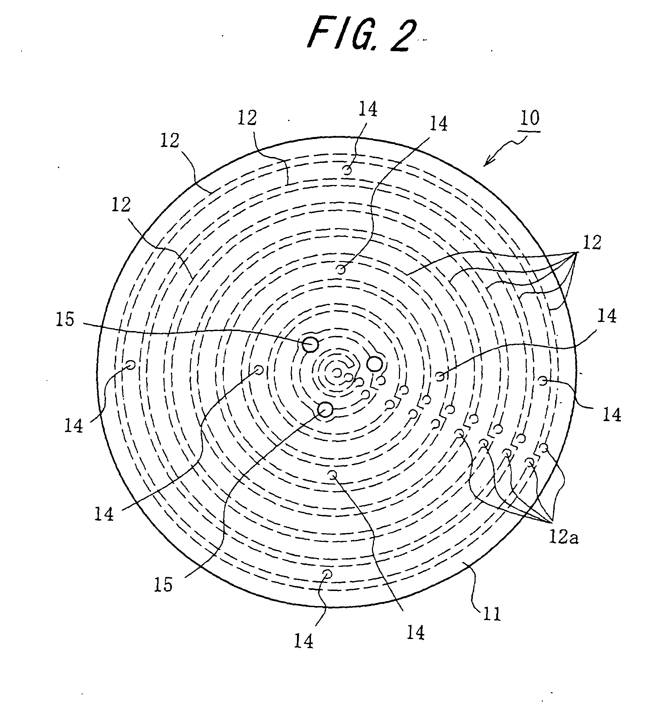

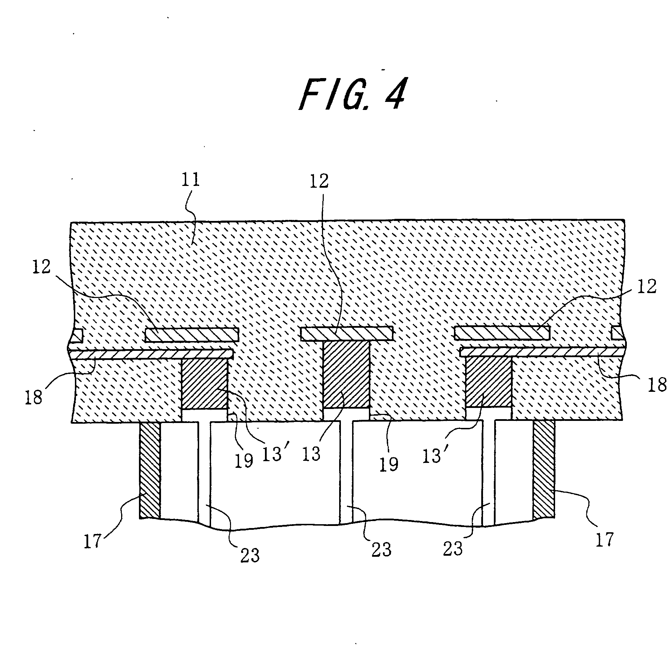

FIG. 2 is a plane view schematically illustrating a hot plate as an example of the ceramic substrate constituting the ceramic composite body according to the invention. FIG. 3 is a section view thereof, and FIG. 4 is a partial enlarged section view in the vicinity of the terminal protection cylinder shown in FIG. 3.

As shown in FIG. 3, in the hot plate 10, the terminal protection cylinder 17 is joined and fixed to the vicinity of the center of the bottom face 11b of the ceramic substrate 11 having a disc shape. In the joining portion between the ceramic substrate 11 and the terminal protection cylinder 17 is formed a ceramic joining interface 21 of aluminum nitride. Further, the terminal protection cylinder 17 is formed so as to close to the bottom plate (not shown) of the support vessel, so that the inside and the outside of the terminal protection cylinder 17 are actually and completely separated though the it is not clearly read from the figure.

Further, it is necessary that the joining assistant layer 21 is formed in the joining interface 21 between the one ceramic substrate 11 and the other ceramic cylinder (terminal protection cylinder) 17 and the coarse pores are formed in the joining assistant layer 21. The joining assistant layer is a layer-like region consisting of the joining assistant or having a relatively high concentration of the joining assistant. The electron microphotograph of the joining interface shown in FIG. 10 clearly shows the structure of the joining assistant layer, in which black pores and white discontinuous joining assistant layer are observed in the central joining interface. The white portion is the yttrium compound and the black portion is the pore. The enlarged photograph is FIGS. 10c and 10d. In a portion of the yttrium compound contacting with AlN is formed YAG (yttrium-aluminum-garnet) which is grey in the photograph.

The average diameter of the coarse pore is not more than 2000 µm, preferably 2-1000 µm. The thickness of the joining assistant layer is 0.1-100 µm. The joining assistant layer strongly adheres the ceramic bodies to each other.

In FIG. 11, the joining assistant layer is not existent in the joining interface between the ceramic body and the other ceramic body, and the ceramic particles grown and integrally complicate into each other to disappear the boundary. Further, the coarse pores are constituted by the boundary between the surface of the ceramic body and grown particles. The size of the coarse pore is about 15 µm as an average diameter, and the thickness of the joining assistant layer is about 5 µm. That is, it is clear from FIGS. 11a, 11b that the coarse pores are continuously existent in the joining interface. Also, it is clear from FIG. 11c that a layer having a relatively large amount of the joining assistant is not confirmed in the joining interface. Because, if a layer having a large amount of yttrium is existent, it is shot whitey by reflection of X-ray.

As shown in FIG. 2, the resistor heating bodies 12 consisting of concentrically arranged circuits are formed in the interior of the ceramic substrate 11. In these resistor heating bodies 12, two mutually closed concentric circles are connected as a set of circuits so as to form a line.

As shown in FIG. 3, a conductor circuit 18 extending in a central direction of the ceramic substrate 11 is formed between the resistor heating body 12 and the bottom face 11b, and the end 12a of the resistor heating body is connected to one end of the conductor circuit 18 through a viahole 130.

The conductor circuit 18 is formed for embedding in the central part of the end portion 12a of the resistor heating body. In the interior of the ceramic substrate 11, a through-hole 13' and a blind hole 19 exposing the through-holes 13' are formed just beneath the other end of the conductor circuit 18 extending to the vicinity of the inside of the terminal protection cylinder 17, and the through-hole 13' is connected to an external terminal 23 having a T shape at its top through a solder layer (not shown).

When the end portion 12a of the resistor heating body is existent inside the terminal protection cylinder 17 the viahole or conductor circuit is not required, so that the through-hole 13 is directly formed in the end part of the resistor heating body and connected to the external terminal 23 through the solder layer.

To the external terminal 23 is attached a socket 25 having an electrically conductive wire 230, and the wire 230 is drawn out from a through-hole formed in the bottom plate (not shown) and connected to a power source or the like (not shown).

On the other hand, a temperature measuring element 180 such as a thermocouple having a lead wire 290 or the like is inserted into the bottomed hole 14 formed in the bottom face 11b of the ceramic substrate 11, which is sealed with a heat resistant resin, ceramic (silica gel or the like) or the like. The lead wire 290 is passed through an insulator (not shown) and drawn out from a through-hole (not shown) formed in the bottom plate of the support vessel toward exterior, and also the interior of the insulator is separated from the exterior. Further, a through-hole 15 for inserting a lifter pin (not shown) is formed in a portion near to the center of the ceramic substrate 11.

The lifter pin can move a material to be treated such as silicon wafer or the like placed thereon in up-down direction. Thus, the pin transfers the silicon wafer to a carrier, which is not shown, or receives the silicon wafer from the carrier, while the pin can place the silicon wafer on the heating face 11a of the ceramic substrate 11 for heating or support the silicon wafer at a state of separating from the heating face 11a by a distance of 50-2000 µm for heating.

Also, a through-hole or recess portion is formed in the ceramic substrate 11 and a support pin having a steepled or semi-spherical shape in its top is inserted into the through-hole or recess portion and thereafter the support pin is fixed at a state of slightly protruding from the ceramic substrate 11 and the silicon wafer is supported by the support pin to heat at a state of holding at a distance separated by 50-2000 µm from the heating face 11a.

Moreover, an inlet tube for a cooling medium or the like, which is not shown, may be arranged on the bottom plate of the support vessel. In this case, a cooling medium is introduced into this inlet tube through a piping, whereby the temperature, cooling rate or the like of the ceramic substrate 11 can be controlled.

In the above hot plate 10, the terminal protection cylinder 17 is joined to the bottom face 11b of the ceramic substrate 11 through a ceramic joining layer 21 and the terminal protection cylinder 17 is attached to the bottom plate, which is not shown, of the support vessel, so that the inside and the outside of the terminal protection cylinder 17 are at a state of completely separating from each other.

Therefore, an electrically conductive wire 230 drawn out from the through-hole of the bottom plate is protected by the tubular member, whereby the surrounding of the hot plate 10 is rendered into an atmosphere containing reactive gas, halogen gas or the like, so that even if the reactive gas or the like is at a state of easily penetrating into the interior of the support vessel, there is caused no corrosion of the wiring or the like inside the terminal protection cylinder 17. Moreover, the wiring 290 from the temperature measuring element 180 is protected by the insulator to cause no corrosion.

Further, an inert gas or the like is slowly flowed into the interior of the terminal protection cylinder 17 so as not to flow the reactive gas, halogen gas or the like into the interior of the terminal protection cylinder 17, whereby the corrosion of the wiring 230 can be more surely prevented.

The terminal protection cylinder 17 has an action of surely supporting the ceramic substrate 11 and can prevent the warping through empty weight even if the ceramic substrate 11 is heated to a high temperature, and hence the breakage of the material to be treated such as silicon wafer or the like can be prevented and the material to be treated can be heated at a uniform temperature.

The ceramic joint body according to the invention itself is described below. As a ceramic forming the ceramic substrate 11 are mentioned nitride ceramic, carbide ceramic, oxide ceramic and the like. The nitride ceramic, carbide ceramic, oxide ceramic and the like are small in the thermal expansion coefficient as compared with the metal and considerably high in the mechanical strength as compared with the metal, so that even if the thickness of the ceramic substrate is thin, there is caused no warping or strain by heating. Therefore, the ceramic substrate can be made thin and light. Further, the thermal conductivity of the ceramic substrate is high and the ceramic substrate itself is thin, so that the surface temperature of the ceramic substrate rapidly follows to the temperature change of the resistor heating body. That is, the surface temperature of the ceramic substrate can be controlled by changing the voltage and current value to change the temperature of the resistor heating body.

Moreover, the nitride ceramic includes, for example, aluminum nitride, silicon nitride, boron nitride, titanium nitride and the like. They may be used alone or in a combination of two or more.

Also, the carbide ceramic includes, for example, silicon carbide, zirconium carbide, titanium carbide, tantalum carbide, tungsten carbide and the like. They may be used alone or in a combination of two or more.

Further, the oxide ceramic includes, for example, alumina, cordierite, mullite, silica, berillia and the like They may be used alone or in a combination of two or more.

Among them, aluminum nitride is most preferable. When the ceramic substrate 11 and the ceramic joining layer 21 are made of the same material, the difference of the thermal expansion coefficient between both substances becomes less, so that the residual stress after the joining becomes small and the crack or the like is not caused in the joint portion. Also, the aluminum nitride is excellent in the corrosion resistance, so that the ceramic substrate 11 is not corroded even in an atmosphere of a corrosive gas Further, the thermal conductivity is as high as 180 W/m·K, so that the temperature followability is excellent.

The ceramic substrate 11 is desirable to have a brightness of not more than N6 as defined in JIS Z 8721. When the brightness is in such a range, radiant heat quantity and shielding property are excellent. In such a hot plate, it is possible to measure an accurate surface temperature by means of a thermoviewer.

As to the brightness N, when an ideal black brightness is 0 and ideal white brightness is 10, it is represented by symbol N0-N10 by dividing colors between the black brightness and the white brightness into 10 so that perception of color brightness is equal step. In this case first of arithmetic point is 0 or 5.

The ceramic substrate 11 having such a characteristic is obtained by including about 100-5000 ppm of carbon into the substrate. As the carbon, there are amorphous carbon and crystalline carbon. The amorphous carbon can suppress the lowering of volume resistivity of the substrate at the high temperature, while the crystalline carbon can suppress the lowering of the thermal conductivity of the substrate at the high temperature, so that the kind of the carbon can be properly selected in accordance with the purpose of the substrate to be produced and the like.

The amorphous carbon can be obtained by firing a hydrocarbon consisting only of C, H and O, preferably saccharides in air. As the crystalline carbon can be used graphite powder and the like. Also, carbon can be obtained by heat-decomposing acrylic resin in an inert atmosphere and heating under pressure, in which the degree of the crystalline property (amorphous property) can be adjusted by changing an acid value of the acrylic resin.

The shape of the ceramic substrate 11 is preferably a disc as shown in FIG. 2, and a diameter thereof is preferably not less than 200 mm, optimally not less than 250 mm. The disc-shaped ceramic substrate 11 is required to have a temperature uniformity because the temperature becomes easily non-uniform as the diameter of the substrate is large.

The thickness of the ceramic substrate 11 is preferably not more than 50 mm, more preferably not more than 20 mm. Also it is optimum to be 1-5 mm. As the thickness is too thin, the warping is easily generated in the heating at the high temperature, while as it is too thick, the heat capacity is too large and the temperature rising and dropping characteristics lower.

Furthermore, the porosity of the ceramic substrate 11 itself is preferable to be 0 or not more than 5%. The porosity is measured by Archimedes process. When the porosity is within the above range, it is effective to suppress the lowering of the thermal conductivity and the occurrence of warping at the high temperature.

As the ceramic constituting the terminal protection cylinder 17 are mentioned nitride ceramic, carbide ceramic, oxide ceramic and the like. Among them, aluminum nitride as the nitride ceramic is most preferable.

When the terminal protection cylinder 17 and the ceramic joining layer 21 are the same material, the difference of thermal expansion coefficient between both the members becomes small and the residual stress after the joining becomes small and there is not caused crack or the like in the joint portion. Also, aluminum nitride is excellent in the corrosion resistance, so that the ceramic substrate 11 is not corroded even in the corrosive gas atmosphere. Further, the thermal conductivity is as high as 180 W/m•K, so that the temperature followability is excellent.

As a pattern of the resistor heating body 12, mention may be made of eddy form, eccentric circular form, a combination of concentric circle and bending lines and the like in addition to the concentric circular form shown in FIG. 2. Also, the resistor heating body 12 is desirable to have a thickness of 1-50 µm and a width of 5-20 µm.

By changing the thickness or width of the resistor heating body 12 can be changed a resistance value, but the above ranges are most practical. The resistance value of the resistor heating body 12 becomes large as the thickness is thin and the width is narrow.

The section of the resistor heating body 12 may be square, ellipsoid, spindle or barrel, but it is desirable to be flat. The flat form easily radiates heat toward the heating face 11a, so that the heat transmission quantity to the heating face 11a can be increased and the temperature distribution on the heating face 11a is hardly generated. Moreover, the resistor heating body 12 may be spiral form.

In the hot plate 10, the number of circuits consisting of the resistor heating body 12 is not less than 1 and is not particularly limited, but it is desirable to form plural circuits for uniformly heating the heating face 11a.

When the resistor heating body 12 is formed in the interior of the ceramic substrate 11, the forming position is not particularly limited, but it is preferable to form at least one layer at a position from the bottom surface 11b of the ceramic substrate 11 to 60% of the thickness thereof. Because, heat is diffused during the propagation to the heating face 11a to easily uniformize the temperature of the heating face 11a.

In the formation of the resistor heating body 12 in the interior of the ceramic substrate 11, it is preferable to use a conductor paste made from a metal or an electrically conductive ceramic. That is, when the resistor heating body 12 is formed in the interior of the ceramic substrate 11, the resistor heating body 12 is formed in the interior by forming a conductor paste layer on a green sheet and laminating green sheets and firing them.

The conductor paste is not particularly limited, it is preferable to contain a resin, a solvent, a thickener and the like in addition to the inclusion of metal particles or electrically conductive ceramic for ensuring the electrical conduction. As the metal particle, noble metal (gold, silver, platinum, palladium), lead, tungsten, molybdenum, nickel and the like are preferable. They may be used alone or in a combination of two or more. These metals are hardly oxidized and have a resistance value enough to generate heat.

The shape of the metal particle may be sphere or flake. When using these metal particles, the mixture of spherical and flaky particles may be used. When the metal particle is a flake or a mixture of sphere and flake, a metal oxide is easily held between the metal particles and the adhesion property between the resistor heating body 12 and the ceramic substrate 11 is ensured and the resistance value can be advantageously increased.

As the electrically conductive ceramic are mentioned carbides of tungsten and molybdenum. They may be used alone or in a combination of two or more. The metal particle or electrically conductive particle is preferable to have a particle size of 0.1-100 µm. When it is less than 0.1 µm, the particles are easily oxidized, while when it exceeds 100 µm, the particles are hardly sintered and the resistance value becomes large.

As the resin used in the conductor paste are mentioned, for example, an epoxy resin, a phenolic resin and the like. As the solvent are mentioned, for example, isopropyl alcohol and the like. As the thickener are mentioned cellulose and the like.

Moreover, when the conductor circuit 18 is formed in the interior of the substrate, the conductor paste made of the metal or electrically conductive ceramic used in the formation of the resistor heating body 12 can be used, and further a conductor paste usually used in the formation of the electrode or the like may be used.

The size of the conductor circuit 18 is not particularly limited, but is preferable to have a width of 0.1-50 mm and a thickness of 0.1-500 µm, and the length is properly adjusted in correspondence with a distance from the end portion of the resistor heating body 12 to an inside of a cylindrical body 17 joined in the vicinity of the center of the ceramic substrate 11.

The hot plate 10 according to the invention is desirable to be used above 100°C, preferably above 200°C.

In the invention, the electrically conductive wire 230 connected to the external terminal 23 through the socket 25 is desirable to be coated with a heat resistant insulative member for preventing short-circuit or the like to the other conductive wire 230. As the insulative member are oxide ceramics such as alumina, silica, mullite, cordierite and the like, silicon nitride, silicon carbide and so on.

In the hot plate 10 shown in FIGS. 2, 3 and 4, the ceramic substrate 11 is usually fitted onto an upper part of a support vessel (not shown). In the other embodiment, however, the substrate is placed on an upper surface of a support vessel having a substrate receiving portion at its upper end and fixed through a fixing member such as bolt or the like. In the invention, a thermocouple can be used as a temperature measuring element 180 as shown in FIG. 3. The temperature of the resistor heating body 12 can be controlled by measuring the temperature through the thermocouple and changing the voltage and current amount based on the measured data.

A size of a lead wire of the thermocouple at the joining position is the same as the wire diameter of the lead wire or larger than that but not more than 0.5 mm. According to such a construction, the heat capacity at the joining portion becomes small and the temperature is accurately and rapidly converted into a current value. Therefore, the temperature followability is improved and the temperature distribution of the wafer to the heating face 11a becomes small.

As the thermocouple are mentioned K-type, R-type, B-type, E-type, J-type, T-type thermocouples as shown in JIS-C-1602 (1980).

In addition to the above thermocouple, there are mentioned temperature measuring elements such as platinum temperature measuring resistor, thermistor and the like as a temperature measuring means for the hot plate 10 according to the invention, and also a temperature measuring means using an optical means such as thermoviewer or the like may be mentioned.

In case of using the thermoviewer, the temperature of the heating face 11a of the ceramic substrate 11 can be measured, but also the temperature of the surface of the material to be heated such as silicon wafer or the like can be directly measured, so that the precision of the temperature control of the material to be heated is improved.

The ceramic substrate constituting the composite according to the invention is used for producing the semiconductor or inspecting the semiconductor, and includes for example, an electrostatic chuck, a susceptor, a hot plate (ceramic heater) and so on.

The aforementioned hot plate is a device in which the resistor heating body is arranged in the interior of the ceramic substrate. This can conduct the heating to a given temperature or the cleaning after the material to be treated such as silicon wafer or the like is placed on the surface of the ceramic substrate or held at a distance separated therefrom.

When the conductor formed in the interior of the ceramic substrate constituting the composite according to the invention is an electrostatic electrode and conductor circuit, the composite functions as an electrostatic chuck.

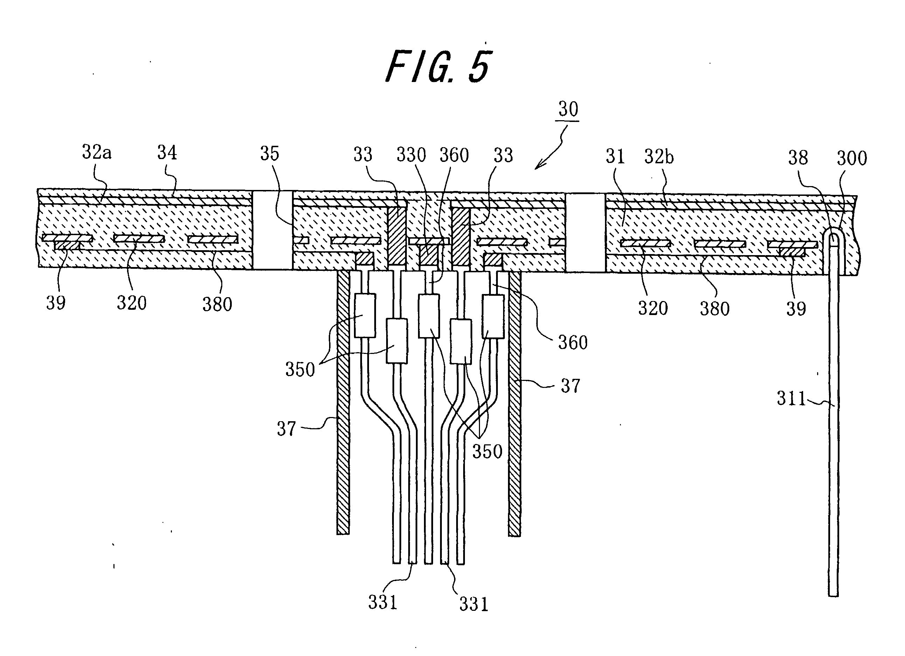

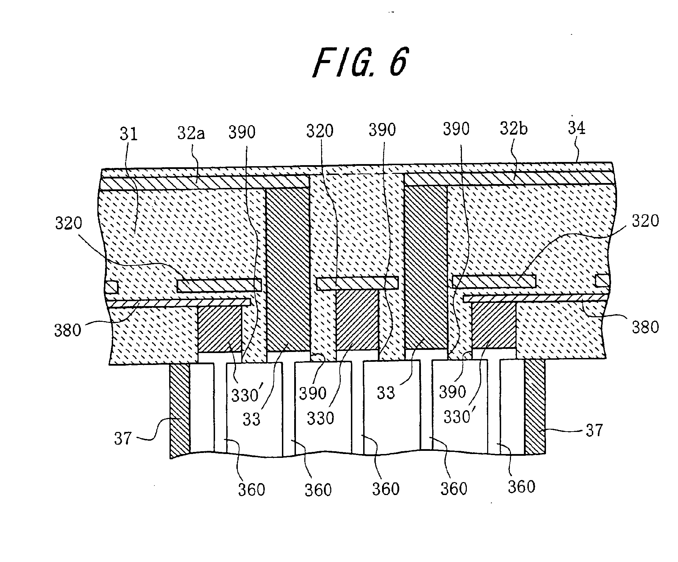

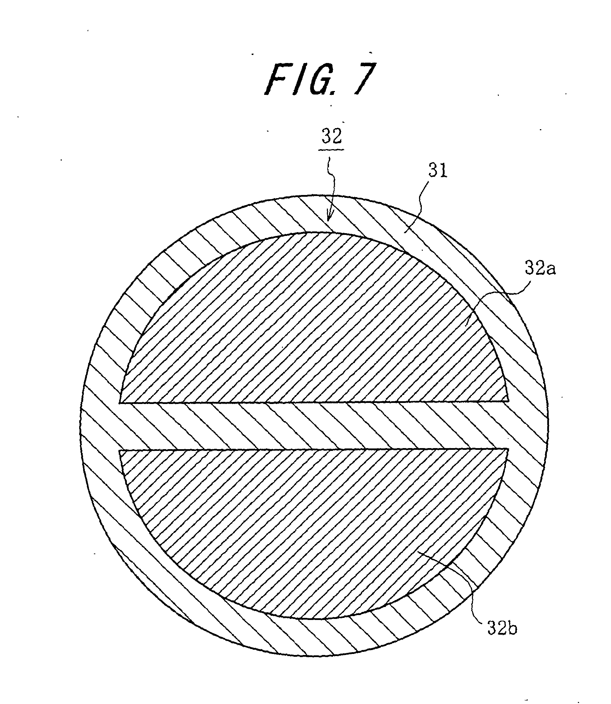

FIG. 5 is a longitudinal section view schematically showing such an electrostatic chuck, and FIG. 6 is a partially enlarged view thereof, and FIG. 7 is a horizontally section view schematically showing the neighborhood of the electrostatic electrode formed in the substrate constituting the electrostatic chuck.

In the interior of the ceramic substrate 31 constituting the electrostatic chuck 30 are arranged semicircular chuck positive and negative electrode layers 32a, 32b opposite to each other, and a ceramic dielectric film 34 is formed on these electrostatic electrodes. Also, the resistor heating body 320 is arranged in the interior of the ceramic substrate 31, which can heat the material to be treated such as silicon wafer or the like. Moreover, an RF electrode may be embedded in the ceramic substrate 31, if necessary.

The electrostatic electrode is preferable to be made of a metal such as noble metal (gold, silver, platinum, palladium), lead, tungsten, molybdenum, nickel or the like, or an electrically conductive ceramic such as carbide of tungsten, molybdenum or the like. Also, they may be used alone or in a combination of two or more.

The electrostatic chuck 30 is constructed in the same manner as in the aforementioned hot plate 10 except that the electrostatic electrodes 32a, 32b are formed in the ceramic substrate 31 and through-holes 33 are formed just beneath the ends of the electrostatic electrodes 32a, 32b and the ceramic dielectric film 34 is formed on the electrostatic electrodes 32 as shown in FIGS. 5 and 6.

That is, the terminal protection cylinder 37 is joined to the vicinity of the center of the bottom face of the ceramic substrate 31, and through-holes 33, 330 are formed in the upper portion of the inside of the terminal protection cylinder 37. These through-holes 33, 330 are connected to electrostatic electrodes 32a, 32b and resistor heating body 320 and connected to an external terminal 360 inserted into the blind hole 390. An end of the external terminal 360 is connected to a socket 350 having an electrically conductive wire 331. The electrically conductive wire 331 is drawn out through a through-hole (not shown) toward exterior.

In case of the resistor heating body 320 having an end portion located outside the terminal protection cylinder 37, viahole 39, conductor circuit 380 and through-hole 330' are formed likewise the case of the hot plate 10 shown in FIGS. 2-4, whereby the end portion of the resistor heating body 320 is extended inside the cylinder 37 (see FIG. 6). Therefore, the external terminal 360 can be housed in the inside of the cylinder 37 by inserting the external terminal 360 into the blind hole 390 exposing the through-hole 330' and connecting thereto.

In case of operating the electrostatic chuck 30, a voltage is applied to the resistor heating body 320 and the electrostatic electrode 32, respectively. Thus, the silicon wafer placed on the electrostatic chuck 30 is heated to a given temperature and electrostatically adsorbed on the ceramic substrate 31. Moreover, the electrostatic chuck may not be necessarily provided with the resistor heating body 320.

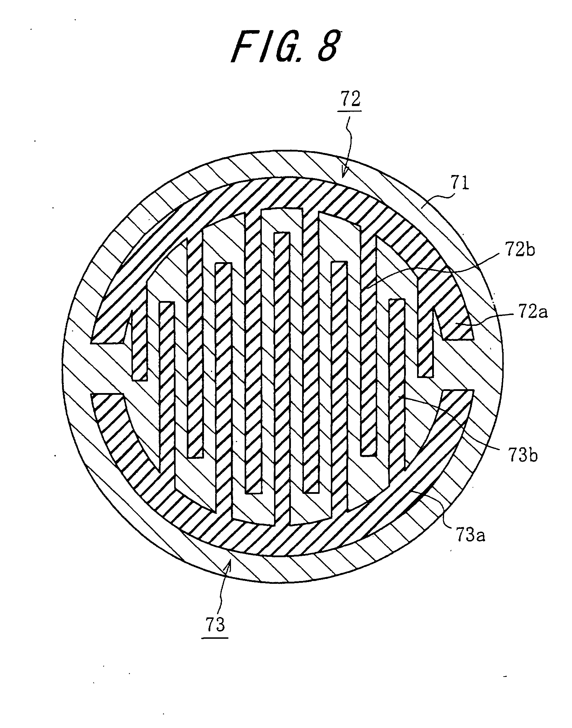

FIG. 8 is a horizontally section view schematically showing electrostatic electrodes formed on a substrate of another electrostatic chuck. In the interior of the substrate 71 are arranged a chuck positive electrostatic electrode layer 72 consisting of a semi-arc-shaped portion 72a and a comb-teeth portion 72b and a chuck negative electrostatic electrode layer 73 consisting of a semi-arc-shaped portion 73a and a comb-teeth portion 73b so as to cross the comb-teeth portions 72b and 73b with each other.

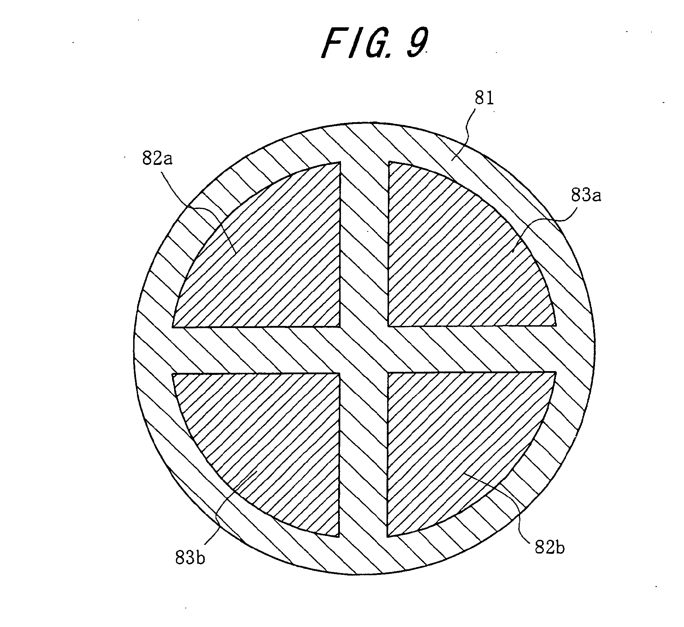

Also, FIG. 9 is a horizontally section view schematically showing electrostatic electrodes formed on a substrate of the other electrostatic chuck. In this electrostatic chuck, chuck positive electrostatic electrode layers 82a, 82b and chuck negative electrostatic electrode layers 83a, 83b of a shape dividing a circle into four parts are formed in the interior of the substrate 81. Also the two chuck positive electrostatic electrode layers 82a, 82b and the two chuck negative electrostatic electrode layers 83a, 83b are formed so as to cross with each other. Moreover, when the electrodes are formed in a form of dividing the electrode of circle or the like, the dividing number is not particularly limited, and the number may be not less than 5, and also the shape is not limited to the fan shape.

### EXAMPLE

The embodiments of the invention are concretely explained below.

### (Example 1) Production of electrostatic chuck (see FIGS. 5-7)

(1) A green sheet having a thickness of 0.47 mm is obtained by using a composition of a mixture of 100 parts by weight of aluminum nitride powder (made by Tokuyama Co., Ltd, average particle size: 0.6 µm), 4 parts by weight of yttria (average particle size: 0.4 µm), 11.5 parts by weight of acrylic resin binder, 0.5 part by weight of a dispersant and 53 parts by weight of 1-butanol and ethanol as an alcohol and shaping it through a doctor blade process
(2) After the green sheet is dried at 80°C for 5 hours, there are prepared a green sheet not subjected to working, a green sheet provided with a through-hole for a viahole by punching for connecting a resistor heating body to a conductor circuit, a green sheet provided with a through-hole for a viahole for connecting the conductor circuit to an external terminal, and a green sheet provided with through-holes for a through-hole for connecting electrostatic electrodes to the external terminal.
(3) A conductor paste A is prepared by mixing 100 parts by weight of tungsten carbide particles having an average particle size of 1 µm, 3.0 parts by weight of acrylic binder, 3.5 parts by weight of α-terpineol solvent and 0.3 part by weight of a dispersant.
   Also, a conductor paste B is prepared by mixing 100 parts by weight of tungsten carbide particles having an average particle size of 3 µm, 1.9 parts by weight of acrylic binder, 3.7 parts by weight of α-terpineol solvent and 0.2 part by weight of a dispersant.
(4) A conductor paste layer as a resistor heating body is formed by printing the conductor paste A on the surface of the green sheet provided with the through-hole for a viahole through a screen printing process. Also, a conductor paste layer as a conductor circuit is formed by printing the electrically conductive paste A on the surface of the green sheet provided with the through-hole for connecting the conductor circuit and the external terminal through a screen printing process. Further, a conductor paste layer having an electrostatic electrode pattern of a shape shown in FIG. 7 is formed on the green sheet not subjected to the working.
   Further, the conductor paste B is filled in the throguh-holes for the through-hole for connecting the through-hole for a viahole for connecting the resistor heating body and the conductor circuit to the external terminal.
   Then, the green sheets after the above treatments are laminated as follows.
   At first, on an upper side (heating face side) of the green sheet printed with the conductor paste layer as a resistor heating body are laminated 34 green sheets formed with only a portion corresponding to through-hole 33, while the green sheet printed with the conductor paste layer as a conductor circuit is laminated on a lower side (bottom face side) thereof, and further 12 green sheets formed with portions corresponding to through-holes 33, 330, 330' are laminated on the lower side thereof.
   On an uppermost part of the thus laminated green sheets is laminated the green sheet printed with the conductor paste layer of the electrostatic electrode pattern, and two green sheets not subjected to the working are laminated thereon, which are pressed at 130°C under a pressure of 8 MPa to form a laminate.
(5) Then, the above laminate is degreased in a nitrogen gas at 600°C for 5 hours and hot-pressed at 1890°C under a pressure of 15 MPa for 3 hours to obtain a ceramic plate body having a thickness of 3 mm. It is cut out into a disc having a diameter of 230 mm to obtain a ceramic substrate 31 having a resistor heating body 320 with a thickness of 5 µm and a width of 2.4 mm, a conductor circuit 380 with a thickness of 20 µm and a width of 10 mm and chuck positive electrostatic electrode layer 32a and chuck negative electrostatic electrode layer 32b with a thickness of 6 µm.
(6) The ceramic substrate 31 obtained in the item (5) is grounded with a diamond grinding stone and a mask is placed thereon and subjected to a blast treatment with glass beads to form a bottomed hole 300 for a thermocouple on the surface, while the through-holes 33, 33' formed portions are cut out from the bottom surface 31b of the ceramic substrate 31 to form blind holes 390.
(7) Granulates are prepared by using a composition of a mixture of 100 parts by weight of aluminum nitride powder (made by Tokuyama Co., Ltd, average particle size: 0.6 µm), 4 parts by weight of yttria (average particle size: 0.4 µm), 11.5 parts by weight of acrylic resin binder 0.5 part by weight of a dispersant and 53 parts by weight of 1-butanol and ethanol as an alcohol through a spray dry process. These granulates are filled in a pipe-shaped mold and sintered at 1890°C under atmospheric pressure and an end face of the sintered body is polished to Rmax = 1 µm and a flatness degree of 2.1 µm, whereby there is prepared a terminal protection cylinder of aluminum nitride having a length of 200 mm, an outer diameter of 52 mm and an inner diameter of 39 mm.
(8) The bottom surfaces of the ceramic substrate and the terminal protection cylinder to be joined are grounded with a diamond grinding stone of #800, polished with a paste having an average particle size of 0.25 µm and subjected to a sand blast treatment with SiC of 1, 10, 50 µm to Rmax = 2, 15, 80 µm, and then an aqueous solution of yttrium chloride having a concentration shown in Table 1 (0.3 mol/l) is applied to the bottom surface 31b of the ceramic substrate 31 and the joining surface of the terminal protection cylinder 37, respectively.
(9) Thereafter, the terminal protection cylinder 37 is placed on the coated ceramic substrate 31 and heated under conditions shown in Table 1 (1750°C) to join the ceramic substrate 31 and the terminal protection cylinder 37. Moreover, the joining is carried out by the dead weight of the terminal protection cylinder without applying a pressure to the ceramic substrate 31 or the terminal protection cylinder 37. Also, the positioning of the terminal protection cylinder 37 is carried out so as to receive the blind hole 390 in the inside of the inner diameter in the joining to the ceramic substrate 11.
(10) Then, an external terminal 360 is attached to the blind hole 390 inside the terminal protection cylinder 37 with a silver solder (Ag: 40% by weight, Cu: 30% by weight, Zn: 28% by weight, Ni: 1.8% by weight, reminder: other elements, reflow temperature: 800°C). Thereafter, an electrically conductive wire 331 is connected to the external terminal 360 through a socket 350.
(11) Further, a thermocouple for the control of the temperature is inserted into a bottomed hole 300 and silica sol is filled therein and cured and gelated at 190°C for 2 hours, whereby the terminal protection cylinder is joined to the bottom surface of the ceramic substrate having the electrostatic electrodes, resistor heating body, conductor circuit, viahole and through-holes in its interior through a ceramic joining layer 21 made of aluminum nitride to produce a ceramic composite body in which the ceramic substrate acts as an electrostatic chuck. The structure of the joining interface is shown in FIG. 10. There are observed pores having a flat shape at section. The average diameter of the sintered ceramic particles is 8 µm in both the ceramic substrate and the protection cylinder.

### (Example 2) Production of hot plate (see FIG. 1 and FIGS. 2-4)

(1) A green sheet having a thickness of 0.47 mm is obtained by using a composition of a mixture of 100 parts by weight of aluminum nitride powder (made by Tokuyama Co., Ltd, average particle size: 0.6 µm), 4 parts by weight of yttria (average particle size: 0.4 µm), 11.5 parts by weight of acrylic resin binder, 0.5 part by weight of a dispersant and 53 parts by weight of 1-butanol and ethanol as an alcohol and shaping it through a doctor blade process.
(2) Then, the green sheet is dried at 80°C for 5 hours and thereafter a portion corresponding to a through-hole 15 for inserting a lifter pin for transporting a silicon wafer or the like, a portion 630 corresponding to a viahole, and portions 63, 63' corresponding to through-holes are formed by punching as shown in FIG. 2.
(3) A conductor paste A is prepared by mixing 100 parts by weight of tungsten carbide particles having an average particle size of 1 µm, 3.0 parts by weight of acrylic binder, 3.5 parts by weight of α-terpineol solvent and 0.3 part by weight of a dispersant.
   A conductor paste B is prepared by mixing 100 parts by weight of tungsten particles having an average particle size of 3 µm, 1.9 parts by weight of acrylic binder, 3.7 parts by weight of α-terpineol solvent and 0.2 part by weight of a dispersant.
   The conductor paste A is printed on the green sheet having the portion 630 corresponding to the viahole through screen printing to form a conductor paste layer 62 for a resistor heating body. The printed pattern is a concentrically circle pattern as shown in FIG. 2, in which the conductor paste layer 62 has a width of 10 mm and a thickness of 12 µm.
   Subsequently, the conductor paste A is printed on the green sheet having the portion 63' corresponding to the through-hole through screen printing to form a conductor paste layer 68 for the conductor circuit. The printed shape is a band.
   Also, the conductor paste B is filled in the portion 630 corresponding to the viahole and the portions 63, 63' corresponding to the through-holes.
   On the green sheet printed with the conductor paste layer 62 are laminated 37 green sheets each not printed with the conductor paste, and the green sheet printed with the conductor paste layer 68 is laminated on the lower face thereof and further 12 green sheets each not printed with the conductor paste are laminated therebelow, which are laminated at 130°C under a pressure of 8 MPa.
(4) The thus obtained laminate is degreased in a nitrogen gas at 600°C for 5 hours and hot pressed at 1890°C under a pressure of 15 MPa for 10 hours to obtain a ceramic plate body having a thickness of 3 mm. It is cut out into a disc having a diameter of 230 mm and grounded at its bottom face to a center-line average roughness (Ra) of 2.2 µm and a flatness degree of 2.2 µm to obtain a ceramic substrate 11 having a resistor heating body 12 with a thickness of 6 µm and a width of 10 mm, a conductor circuit 18 with a thickness of 20 µm and a width of 10 mm, viahole 130 and through-holes 13, 13'.
(5) The ceramic substrate 11 obtained in the item (4) is grounded with a diamond grinding stone and a mask is placed thereon and subjected to a blast treatment with glass beads to form a bottomed hole 14 for a thermocouple on the surface, while the through-holes 13, 13' formed portions are cut out from the bottom surface 11b of the ceramic substrate 11 to form blind holes 19.
(6) Granulates are prepared by using a composition of a mixture of 100 parts by weight of aluminum nitride powder (made by Tokuyama Co., Ltd, average particle size: 0.6 µm), 4 parts by weight of yttria (average particle size: 0.4 µm), 11.5 parts by weight of acrylic resin binder 0.5 part by weight of a dispersant and 53 parts by weight of 1-butanol and ethanol as an alcohol through a spray dry process. These granulates are filled in a cylindrical mold and sintered at 1890°C under atmospheric pressure and an end face of the sintered body is polished to Rmax = 0.2 µm and a flatness degree of 2.2 µm, whereby there is prepared a terminal protection cylinder 17 of aluminum nitride having a length of 200 mm, an outer diameter of 52 mm and an inner diameter of 39 mm.
(7) The bottom surfaces of the ceramic substrate and the terminal protection cylinder to be joined are grounded with a diamond grinding stone of #800, polished with a paste having an average particle size of 0.25 µm and subjected to a sand blast treatment with SiC of 0.1, 50, 100 µm to Rmax = 0.2, 80, 120 µm and a flatness of 2.0 µm, and then an aqueous solution of yttrium nitrate having a concentration shown in Table 2 (0.11 mol/l) is applied to the bottom surface 31b of the ceramic substrate 31 and the joining surface of the terminal protection cylinder 37, respectively.
(8) The terminal protection cylinder 37 is placed on the coated ceramic substrate 31 and heated at 1800°C to join the ceramic substrate 31 and the terminal protection cylinder 37.
   Moreover, the joining is carried out by the dead weight of the terminal protection cylinder without applying a pressure to the ceramic substrate 31 or the terminal protection cylinder 37. Also, the ceramic substrate 11 and the terminal protection cylinder 37 are joined at a position so as to receive the blind hole 390 in the inside of the inner diameter.
(9) Then, an external terminal 23 is attached to the blind hole 19 inside the terminal protection cylinder 37 with a silver solder (Ag: 40% by weight, Cu: 30% by weight, Zn: 28% by weight, Ni: 1.8% by weight, reminder: other elements, reflow temperature: 800°C). Thereafter, an electrically conductive wire 230 is connected to the external terminal 23 through a socket 25.
(10) Further, a thermocouple for the control of the temperature is inserted into a bottomed hole 14 and silica sol is filled therein and cured and gelated at 190°C for 2 hours, whereby the terminal protection cylinder of aluminum nitride is joined to the bottom surface of the ceramic substrate having the resistor heating body, conductor circuit, viahole and through-holes to produce a ceramic composite body in which the ceramic substrate acts as a hot plate. The structure of the joining interface is shown in FIG. 11 There are observed pores having a flat shape at section.
   Moreover, the average diameter of the sintered ceramic particles is 8 µm in both the ceramic substrate and the protection cylinder.

### (Example 3)

The same procedure as Example 1 is repeated except that silicon nitride having an average particle size of 0.8 µm is used. Also, an aqueous solution of 0.1 mol/l ytterbium nitrate is used as a joining assistant. The average diameter of the sintered ceramic particles is 5 µm in both the ceramic substrate and the protection cylinder.

### (Example 4)

The same procedure as Example 2 is repeated except that the average diameter of the ceramic particles is 8 µm in both the ceramic substrate and the protection cylinder. The average pore size is adjusted to 8, 1000, 2000 µm.

### (Example 5)

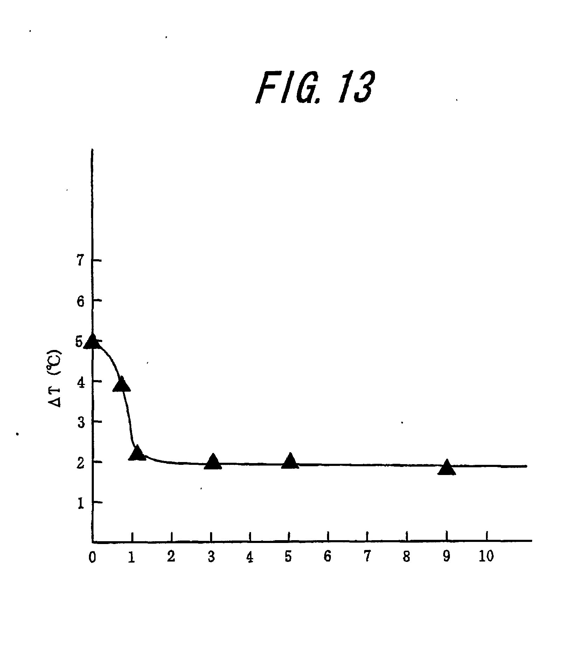

The same procedure as Example 1 is repeated except that the temperature is raised to 450°C and the thickness of the joining layer is constant at 28 µm and the aspect ratio is changed by adjusting the average diameter of the coarse pore. The difference between maximum temperature and minimum temperature on the surface of the ceramic substrate (heater plate) is measured by means of a thermoviewer and the relation thereof is shown as a graph (FIG. 13).

### (Example 6)

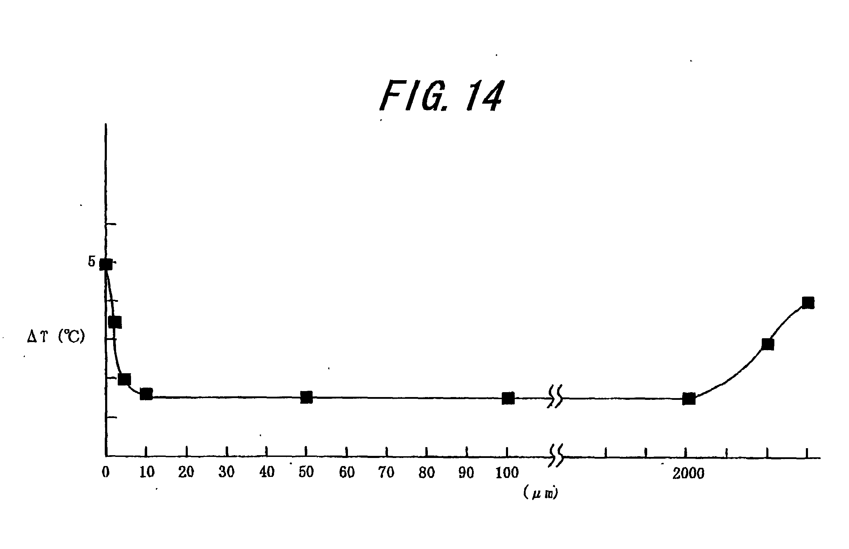

The same procedure as Example 2 is repeated except that the temperature is raised to 450°C and the average diameter of the coarse pores is changed. The difference between maximum temperature and minimum temperature on the surface of the ceramic substrate (heater plate) is measured by means of a thermoviewer and the relation thereof is shown as a graph (FIG. 14).

### (Comparative Example 1)

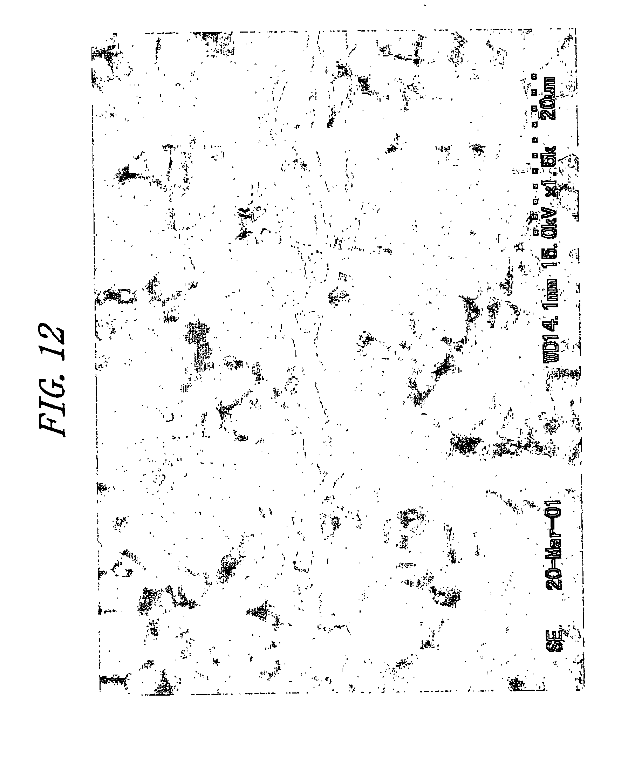

A ceramic composite body is prepared in the same manner as in Example 1 except that the surface of the ceramic substrate 31 to be joined is polished with a diamond paste having an average particle size of 0.25 µm to Rmax of 0.05 µm, and the flatness degree of the terminal protection cylinder 37 is made to 2.0 µm, and 0.26 mol/l of yttrium nitrate is applied to the surfaces of the ceramic substrate 31 and terminal protection cylinder 37 to be joined, and the terminal protection cylinder 37 is placed on the ceramic substrate 31 and fired from 1850 to 1950°C. The structure of the joining interface is shown in FIG. 12.

Moreover, the figure shows a dense joining interface without pores. A white stripe is seen in the joining interface, which is a layer of yttrium compound.

Moreover, recesses from removal of particles in the grinding of the joining interface are filled with the joining assistant, so that the pores are not found by observation of the section.

### (Comparative Example 2)

The same procedure as Comparative example 1 is repeated except that silicon nitride is used. Also, ytterbium chloride is used as a joining assistant.

### (Comparative Example 3)

A ceramic composite body is prepared in the same manner as in Example 1 except that the surface of the ceramic substrate 31 to be joined is polished with a diamond paste having an average particle size of 0.25 µm to Rmax of 0.05 µm, and the flatness degree of the terminal protection cylinder 37 is made to 2.0 µm, and 0.28 mol/l of yttrium nitrate is applied to the surfaces of the ceramic substrate 31 and terminal protection cylinder 37 to be joined, and the terminal protection cylinder 37 is placed on the ceramic substrate 31 and fired at 1900°C. As the joining interface is observed, there are existent the joining assistant layer and pores in the joining assistant layer. The average diameter of the sintered ceramic particles is 8 µm, and the pore is 4 µm.

### (Comparative Example 4)

The same procedure as Example 1 is repeated except that the solution having a concentration of 0.3 mol/l is applied and the heating treatment of 1850°C is conducted. Since the heating temperature is high, the joining assistant is diffused to make the pores large and the average diameter is 2050 µm.

With respect to the ceramic composite bodies of Examples 1 and 2 and Comparative Example 1 are carried out the following evaluation tests. The results are shown in Table 1.

### (Comparative Example 5)

The same procedure as Example 3 is repeated except that the average diameter of the coarse pore is adjusted to 1 µm, 2050 µm.

### (Comparative Example 6)

The same procedure as Comparative Example 1 is repeated except that the polishing is conducted with a diamond paste having an average particle size of 10 nm to Ra = 0.1 µm and Rmax = 0.01 µm. The joining interface has no pore likewise FIG. 12 and is a dense joining interface. In the joining interface is existent a white stripe of yttrium compound layer, but the pore is not existent.

### (1) Measurement of strength at break

The strength at break of the joint portion is measured at 25°C and 500°C by a bending strength test.

### (2) Thermal shock test

The degree of growing the crack is measured by heating at 450°C and immersing a ceramic substrate portion in water.

### (3) Corrosion state of joining interface

The composite body of each of the examples and comparative examples is attached to a support vessel and left to stand in a CF₄ gas atmosphere plasmaed by 1000 W for 2 hours to examine the corrosion state of the joining interface. In general, aluminum nitride is fluorinated to hardly progress the etching, but the joining interface thereof is easily corroded because the crystal structure is different.

**Table 1**

| | Surface roughness (µm) | Temperature (°C) | Strength at break (MPa) | | Crack | Corrosion | Average diameter (µm) |
|---|---|---|---|---|---|---|---|
| | | | 25°C | 600°C | | | |
| Example1 | 2 | 1800 | 410 | 400 | not reach to cylinder | absence | 15 |
| | 15 | 1800 | 420 | 410 | not reach to cylinder | absence | 8 |
| | 80 | 1800 | 450 | 441 | not reach to cylinder | absence | 100 |
| Example2 | 0.2 | 1800 | 410 | 400 | not reach to cylinder | absence | 10 |
| | 80 | 1800 | 450 | 440 | not reach to cylinder | absence | 1000 |
| | 120 | 1800 | 460 | 451 | not reach to cylinder | absence | 1500 |
| Comparative Example1 | 0.05 | 1800 | 390 | 340 | reach to cylinder | presence | 0 |
| | 0.05 | 1850 | 389 | 350 | reach to cylinder | presence | 0 |
| | 0.05 | 1900 | 380 | 340 | reach to cylinder | presence | 0 |
| Example 3 | 0.2 | 1800 | 920 | 915 | not reach to cylinder | absence | 10 |
| | 80 | 1800 | 930 | 923 | not reach to cylinder | absence | 1000 |
| | 120 | 1800 | 950 | 944 | not reach to cylinder | absence | 1500 |
| Comparative Example 2 | 0.05 | 1850 | 860 | 800 | reach to cylinder | presence | 0 |
| | 0.05 | 1950 | 830 | 780 | reach to cylinder | presence | 0 |
| | 0.05 | 1900 | 820 | 760 | reach to cylinder | presence | 0 |
| Comparative Example3 | 0.05 | 1850 | 410 | 370 | reach to cylinder | presence | 4.0 |
| Comparative Exampl 4 | 2 | 1850 | 280 | 220 | reach to cylinder | presence | 2050 |
| Example 4 | 0.1 | 1800 | 415 | 399 | not reach to cylinder | absence | 8 |
| | 10 | 1800 | 443 | 428 | not reach to cylinder | absence | 100 |
| | 200 | 1800 | 461 | 450 | not reach to cylinder | absence | 2000 |
| Comparative Example 5 | 0.05 | 1800 | 840 | 780 | reach to cylinder | presence | 1 |
| | 210 | 1800 | 845 | 788 | reach to cylinder | presence | 2050 |
| Comparative Example 6 | Rmax=0.01 Ra=0.1 | 1900 | 390 | 340 | reach to cylinder | presence | 0 |

As seen from the results of Table 1, the strength at break of the ceramic composite bodies of Examples 1, 2, 3 does not lower as compared with that of Comparative Examples 1, 2, and the joining interface of their joint bodies is not corroded with CF₄ gas. Further, the crack grows to only the substrate. On the other hand, the corrosion is observed in the joint body of Comparative Example 1 and reaches to the cylinder.

As seen from Comparative Example 6, Ra = 0.1 µm forms a mirror surface and the pores can not be formed.

Further, it can be seen from FIG. 13 that when the aspect ratio of the pores is not less than 1, the effect of lowering the concentration at the side of the ceramic substrate is remarkable. This is guessed to be due to the fact that the pore having a flat sectional shape is large in the effect of resisting to heat as previously mentioned.

Furthermore, it is understood that when the size of the pore is not less than 1/2 of the average diameter of the ceramic particle constituting the ceramic body, the effect of resisting to heat remarkable as shown in FIG. 14. If the size of the pore is less than 1/2 of the average diameter of the ceramic particle constituting the ceramic body, heat easily transmits through the contact of the particles with each other and the resisting to heat lowers. On the other hand, when the size of the ceramic particle exceeds 2000 µm, the temperature distribution becomes large, so that it is guessed that the heat transmission through radiant in the pore is predominant and the function of resisting to heat lowers.

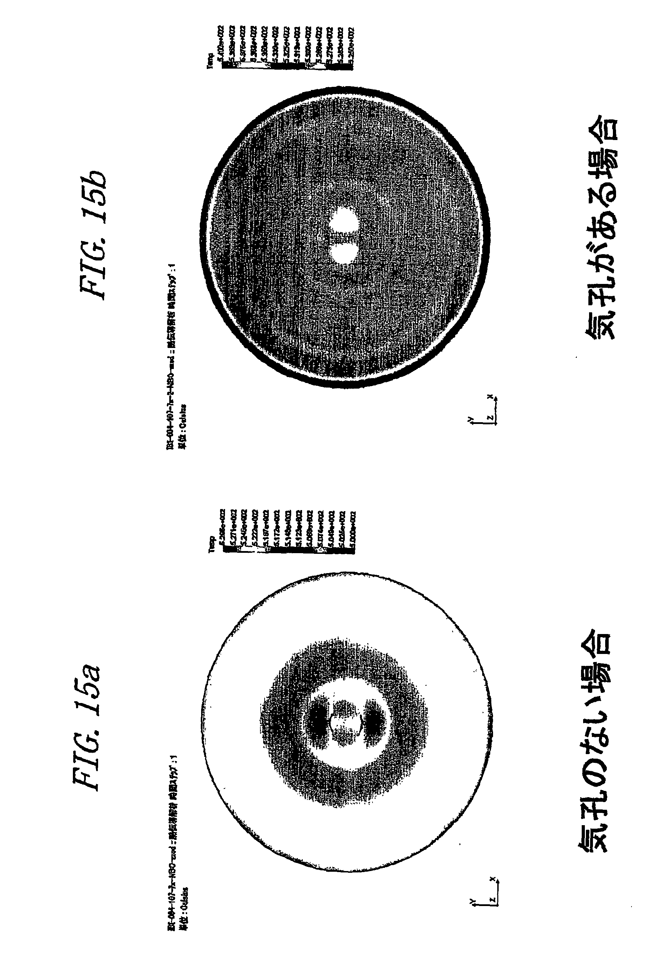

FIGS. 15a and 15b are graphs by a thermoviewer showing the comparison of temperature distribution of the heating face in the ceramic substrate between the case of existing the pores and the case of not existing pores. The pore corresponds to Example 1 and has an average diameter of 100 µm and an aspect ratio of 50. That is, it is understood that since the pores are existent in the joining interface of the ceramic bodies, the temperature uniformity of the heating face in the ceramic substrate is improved.

### INDUSTRIAL APPLICABILITY

The ceramic joint body according to the invention has effects in the corrosion resistance and the control of crack growth because the pores are introduced into the joining interface of ceramic bodies, so that it can be used as a ceramic structural body such as hot plate, electrostatic chuck, susceptor or the like used in various semiconductor production and inspection devices including etching-plasma CVD.

Also, the invention can be used as not only a hot plate for heating a semiconductor wafer but also a temperature controller for an optical waveguide formed by fixing an optical waveguide to the heating face of the ceramic substrate through an adhesive such as epoxy resin or the like, or screw.

## Claims

1. A ceramic joint body formed by joining ceramic bodies to each other, **characterized in that** pores are formed in a joining interface between one of the ceramic bodies and the other ceramic body.

2. A ceramic joint body formed by joining one ceramic body to the other ceramic body, **characterized in that** a joining assistant layer is arranged in a joining interface between the one ceramic body and the other ceramic body and pores are formed in the joining assistant layer.

3. A ceramic joint body formed by joining one ceramic body to the other ceramic body, **characterized in that** at least a part of ceramic particles constituting the each ceramic body and existing in a joining interface is constituted by grown particles mutually penetrated into the ceramic substrate and the ceramic body on the other side across the joining interface and pores are formed in the joining interface.

4. A ceramic joint body according to claim 1, 2 or 3, wherein the pore is a coarse pore having a size of not more than 2000 µm.

5. A ceramic joint body formed by joining ceramic bodies, **characterized in that** coarse pores having an average diameter larger than 1/2 of an average particle size of ceramic particle constituting the ceramic body and a size of not more than 2000 µm are formed in a joining interface between the one ceramic body and the other ceramic body.

6. A ceramic joint body formed by joining one ceramic body to the other ceramic body, **characterized in that** a joining assistant layer is arranged in the joining interface between the one ceramic body and the other ceramic body and coarse pores having an average diameter larger than 1/2 of the average particle size of the ceramic particle constituting the ceramic body and a size of not more than 2000 µm are formed in the joining assistant layer.

7. A ceramic joint body formed by joining one ceramic body to the other ceramic body, **characterized in that** at least a part of the ceramic particles constituting each ceramic body and existing in the joining interface is constructed with grown particles mutually penetrated into the ceramic substrate and the ceramic body across the joining interface and coarse pores having an average diameter larger than 1/2 of the average particle size of the ceramic particle constituting the ceramic body and a size of not more than 2000 µm are formed in the joining interface.

8. A ceramic joint body formed by joining ceramic bodies to each other, **characterized in that** coarse pores having an average diameter larger than an average particle size of a ceramic particle constituting the ceramic body and a size of not more than 2000 µm are formed in a joining interface between the one ceramic body and the other ceramic body.

9. A ceramic joint body formed by joining the one ceramic body to the other ceramic body, **characterized in that** a joining assistant layer is arranged in the joining interface between the one ceramic body and the other ceramic body and coarse pores having an average diameter larger than the average particle size of the ceramic particle constituting the ceramic body and a size of not more than 2000 µm are formed in the joining assistant layer.

10. A ceramic joint body formed by joining one ceramic body to the other ceramic body, **characterized in that** at least a part of the ceramic particles constituting each ceramic body and existing in the joining interface is constructed with grown particles mutually penetrated into the ceramic substrate and the ceramic body across the joining interface and coarse pores having an average diameter larger than the average particle size of the ceramic particle constituting the ceramic body and a size of not more than 2000 µm are formed in the joining interface.

11. A ceramic joint body according to claim 10, wherein the coarse pores formed in the joining interface are pores formed among the surface of the one ceramic body, the surface of the other ceramic body and grown particles produced by the grain growth irrespectively of opened pores or closed pores in the ceramic body.

12. A ceramic joint body according to claim 8, 9 or 10, wherein the surface roughness of the joining face of the ceramic body is Rmax = not less than 0.1 µm by JIS B0601.

13. A ceramic structural body formed by joining a ceramic substrate provided in its inside with a conductor to a ceramic body, **characterized in that** pores are formed in a joining interface between the ceramic substrate and the ceramic body.

14. A ceramic structural body formed by joining the ceramic substrate provided in its inside with the conductor to the ceramic body, **characterized in that** a joining assistant layer is arranged in the joining interface between the ceramic substrate and the ceramic body and pores are formed in the joining assistant layer.

15. A ceramic structural body formed by joining the ceramic substrate provided in its inside with the conductor to the ceramic body, **characterized in that** at least a part of the ceramic particles constituting the ceramic substrate and the ceramic body is constructed with grown particles mutually penetrated into the ceramic substrate and the ceramic body across the joining interface and pores are formed in the joining interface.

16. A ceramic structural body according to claim 13, 14 or 15, wherein the pores are coarse pores having a size of not more than 2000 µm.

17. A ceramic structural body formed by joining a ceramic substrate provided in its inside with a conductor to a ceramic body, **characterized in that** coarse pores having an average diameter larger than 1/2 of an average particle size of ceramic particles constituting the ceramic body and a size of not more than 2000 µm are formed in a joining interface between the ceramic substrate and the ceramic body.

18. A ceramic structural body formed by joining the ceramic substrate provided in its inside with the conductor to the ceramic body, **characterized in that** a joining assistant layer is arranged in the joining interface between the ceramic substrate and the ceramic body and coarse pores having an average diameter larger than 1/2 of the average particle size of the ceramic particles constituting the ceramic body and a size of not more than 2000 µm are formed in the joining assistant layer.

19. A ceramic structural body formed by joining the ceramic substrate provided in its inside with the conductor to the ceramic body, **characterized in that** at least a part of the ceramic particles constituting the ceramic substrate and the ceramic body is constructed with grown particles mutually penetrated into the ceramic substrate and the ceramic body across the joining interface and coarse pores having an average diameter larger than 1/2 of the average particle size of the ceramic particles constituting the ceramic body and a size of not more than 2000 µm are formed in the joining interface.

20. A ceramic structural body formed by joining a ceramic substrate provided in its inside with a conductor to a ceramic body, **characterized in that** coarse pores having an average diameter larger than an average particle size of ceramic particles constituting the ceramic body and a size of not more than 2000 µm are formed in a joining interface between the ceramic substrate and the ceramic body.

21. A ceramic structural body formed by joining the ceramic substrate provided in its inside with the conductor to the ceramic body, **characterized in that** a joining assistant layer is arranged in the joining interface between the ceramic substrate and the ceramic body and coarse pores having an average diameter larger than the average particle size of the ceramic particles constituting the ceramic body and a size of not more than 2000 µm are formed in the joining assistant layer.

22. A ceramic structural body formed by joining the ceramic substrate provided in its inside with the conductor to the ceramic body, **characterized in that** at least a part of the ceramic particles constituting the ceramic substrate and the ceramic body is constructed with grown particles mutually penetrated into the ceramic substrate and the ceramic body across the joining interface and coarse pores having an average diameter larger than the average particle size of the ceramic particles constituting the ceramic body and a size of not more than 2000 µm are formed in the joining interface.

23. A ceramic structural body according to claim 22, wherein the coarse pores formed in the joining interface are pores formed among the surface of the one ceramic body, the surface of the other ceramic body and grown particles produced by the grain growth irrespectively of opened pores or closed pores in the ceramic substrate and ceramic body.

24. A ceramic structural body according to any one of claims 20-23, wherein a conductor body electrically connected to a conductor body inside the ceramic substrate is embedded in the interior of the ceramic body or received in a cylindrical inside of a cylindrical ceramic body.

25. A ceramic structural body according to any one of claims 20-24, wherein a surface roughness of the joining face between the ceramic substrate and the ceramic body is JIS B0601 Rmax = not less than 0.1 µm.

26. A ceramic structural body according to any one of claims 1-25, wherein the ceramic particles is aluminum nitride or silicon nitride, and the joining assistant is one or more of a yttrium compound and a ytterbium compound.

27. A method of forming a ceramic composite body by joining one ceramic body to the other ceramic body, **characterized in that** a surface of at least one of these ceramic bodies to be joined is first mirror-polished to less than 0.1 µm of Rmax and then the mirrored surface is subjected to a blast treatment so as to be a roughness having Rmax of not less than 0.1 µm, and a joining assistant using a yttrium compound and/or ytterbium compound is directly or indirectly applied to the joining surface and fired at a temperature of not higher than 1800°C.
